# EUROPEAN PATENT SPECIFICATION

(11) **EP 0 086 307 B1**
(45) Date of publication and mention of the grant of the patent: **26.02.1997**
(21) Application number: 82306902.6
(22) Date of filing: 23.12.1982
(51) Int. Cl.: G06F 15/76

(54) **Microcomputer system for digital signal processing**
Mikrorechnersystem für digitale Datenverarbeitung
Système microordinateur pour traitement numerique de signaux

(30) Priority: 11.02.1982 US 347859; 11.02.1982 US 347860; 22.02.1982 US 350852
(43) Date of publication of application: 24.08.1983
(60) Divisional application: 90100185.9
(73) Proprietor: TEXAS INSTRUMENTS INCORPORATED, Dallas Texas 75265 (US)
(72) Inventor: Caudel, Edward R., Houston Texas 77072 (US); Magar, Surendar S., Houston Texas 77072 (US)
(74) Representative: Abbott, David John

(56) References cited:
- EP-A- 0 098 685
- US-A- 4 153 933
- US-A- 4 179 734
- "A Microcomputer with Digital Signal Processing Capability", 1982 IEEE International Solid-State Circuits Conference, Wednesday, February 10, 1982/Continental Ballrooms 5-9/11:15 AM./WAM 2.5, pages 32, 33, 284, 285
- ELECTRONIC DESIGN, vol. 28, no. 4, February 1980, pages 137-140; St. Rochelle Park, US; G.P. EDWARDS: "Programmable signalprocessor LSI rivals analog-circuit filters."
- THE BELL SYSTEM TECHNICAL JOURNAL, vol. 60, no. 7, Part 2, September 1981, pages 1449-1462; Murrea Hill, New Jersey, US; J.R. BODDIE et al.: "Digital signal processor: Architecture and performance."
- ELECTRONICS INTERNATIONAL, vol. 53, no. 26, December 4, 1980, pages 79-80; New York, US; R.P. CAPECE: "Digital n-MOS chip handles analog signals at record 200 kHZ."
- ELECTRONICS, vol. 52, no. 26, December 20, 1979, pages 109-115; New York, US; L. SCHIRM: "Packing a signal processor onto a single digital board."
- ELECTRONIQUE INDUSTRIELLE, no. 6, November 15, 1980, pages 43-44; Paris, FR; H. LILEN: "La série 40: Une famille de microsystèmes 4 bits en CMOS."
- ELECTRICAL DESIGN NEWS, vol. 25, no. 7, April 5, 1980, page 153; Denver, US; Feature products: "Digital signalprocessing IC features 250-nsec decode time."
- PROCEDDINGS OF THE FALL JOINT COMPUTER CONFERENCE, vol. 35, November 18-20, 1969, Las Vegas, Nevada, pages 89-98; AFIPS Press, Montvale, N.J., US; C.V. RAMAMOORTHY et al.: Fast multiplication cellular arrays for LSI implementation."

## Description

### BACKGROUND OF THE INVENTION:

This invention relates to integrated semiconductor devices and systems, and more particularly to features of a high-speed, miniaturized, electronic digital signal processing system in single-chip microcomputer form.

A microprocessor device is a central processing unit or CPU for a digital processor which is usually contained in a single semiconductor integrated circuit or "chip" fabricated by "MOS/LSI" technology, as shown in U.S. Patent No. 3,757,306 issued to Gary W. Boone and assigned to Texas Instruments. The Boone patent shows a single-chip 8-bit CPU including a parallel ALU, registers for data and addresses, an instruction register and a control decoder, all interconnected using the Von Neumann architecture and employing a bidirectional parallel bus for data, address and instructions. U.S. Patent No. 4,074,351, issued to Gary W. Boone and Michael J. Cochran, assigned to Texas Instruments, shows a single-chip "microcomputer" type device which contains a 4-bit parallel ALU and its control circuitry, with on-chip ROM for program storage and on-chip RAM for data storage, constructed in the Harvard architecture. The term microprocessor usually refers to a device employing external memory for program and data storage, while the term microcomputer refers to a device with on-chip ROM and RAM for program and data storage; the terms are also used interchangeably, however, and are not intended as restrictive as to some features of this invention.

Subsequent to 1971 when U.S. Patents 3,757,306 and 4,074,351 were originally filed, many improvements have been made in microprocessors and microcomputers to increase the speed and capability of these devices and reduce the cost of manufacture, providing more circuitry and functions in less space, i.e., smaller chip size. Improved VLSI semiconductor processing and photolithographic techniques allow narrower line widths and higher resolution, providing added circuit density and higher speed, but circuit and system improvements also contribute to the goals of increased performance with smaller chip size. Some of these improvements in microcomputers are disclosed in the following U.S. Patents, all assigned to Texas Instruments: No. 3,991,305 issued to Edward R. Caudel and Joseph H. Raymond Jr.; No. 4,156,927 issued to David J. McElroy and Graham S. Tubbs; No. 3,934,233 issued to R.J. Fisher and G.D. Rogers; No. 3,921,142 issued to J.D. Bryant and G.A. Hartsell; No. 3,900,722 issued to M.J. Cochran and C.P. Grant; No. 3,932,846 issued to C.W. Brixey et al; No. 3,939,335 issued to G.L. Brantingham, L.H. Phillips and L.T. Novak; No. 4,125,901 issued to S.P. Hamilton, L.L. Miles, et al; No. 4,158,432 issued to M.G. VanBavel; No. 3,757,308 and No. 3,984,816. The devices described in these patents have been of the Harvard architecture and of the 4-bit type, particularly adapted for calculator or controller applications.

Additional examples of microprocessor and microcomputer devices in the evolution of this technology are described in publications. In Electronics, September 25, 1972, pp. 31-32, a 4-bit P-channel MOS microcomputer with on-chip ROM and RAM is shown which is similar to Patent 3,991,305. Two of the most widely used 8-bit microprocessors like that of Patent 3,757,306 are described in Electronics, April 18, 1974 at pp. 88-95 (the Motorola 6800) and pp. 95-100 (the Intel 8080). A microcomputer version of the 6800 is described in Electronics, February 2, 1978 at pp. 95-103. Likewise, a single-chip microcomputer version of the 8080 is shown in Electronics, November 25, 1976 at pp. 99-105. Another single-chip microcomputer, the Mostek 3872, is shown in Electronics, May 11, 1978, at p. 105-110, and an improved version of the 6800 is disclosed in ELectronics, September 17, 1979 at pp. 122-125. Sixteen-bit microprocessors based on minicomputer instruction sets evolved such as the part number TMS9900 described in a book entitled "9900 Family Systems Design", published in 1978 by Texas Instruments Incorporated, P.O. Box 1443, M/S 6404, Houston, Texas 77001, Library of Congress Catalog No. 78-058005. The 8086, a 16-bit microprocessor evolving from the 8080, is described in Electronics, February 16, 1978, pp. 99-104, while a 16-bit microprocessor identified as the 68000 (based on the 6800) is described in Electronic Design, September 1, 1978 at pp. 100-107, and in IEEE Computer, Vol. 12. No. 2, pp. 43-52 (1979).

These prior 8-bit and 16-bit microprocessors and microcomputers have been general-purpose processors of the Von Neumann architecture with multiplexed address/ data busses; some have been microcoded as described in U.S. Patent Application S.N. 209,915, filed November 24, 1980 by Guttag, McDonough and Laws, or S.N. 253,624, filed April 13, 1981, by Hayn, McDonough and Bellay, both assigned to Texas Instruments, and at pp. 28-34, IEEE Spectrum, March 1979, by McKevitt and Bayliss, or Proceedings 11th Annual Microprogramming Workshop, December, 1979 by Stintter and Tredenick. Microcoding, originally described by Wilkes in 1951, employs a control ROM to store microinstruction sequences entered by instruction words; the programmer works in a higher level machine code, so the number of assembly language code statements is supposedly reduced, and thus programming cost is reduced.

In Electronique Industrielle for 15 November 1980, pages 43 and 44, there is an article entitled "La Série 40: une famille de microsystèmes 4 bits en CMOS", on which the preamble to claim 1 is based, in which there is described the type 5840 microcomputer manufactured by OKI. That device includes a data RAM connected to a data bus, a program ROM connected to a program bus, and a PLA control circuit controlling an ALU. The arithmetic logic unit can be used by both data and programs.

In contrast, features of the invention may be preferably employed in a special-purpose high-speed microcomputer device according to the embodiment described herein which departs from these contemporary microprocessor devices in several major respects in order to achieve substantial speed and performance advantages. This device is generally a non-microcoded processor of modified Harvard architecture.

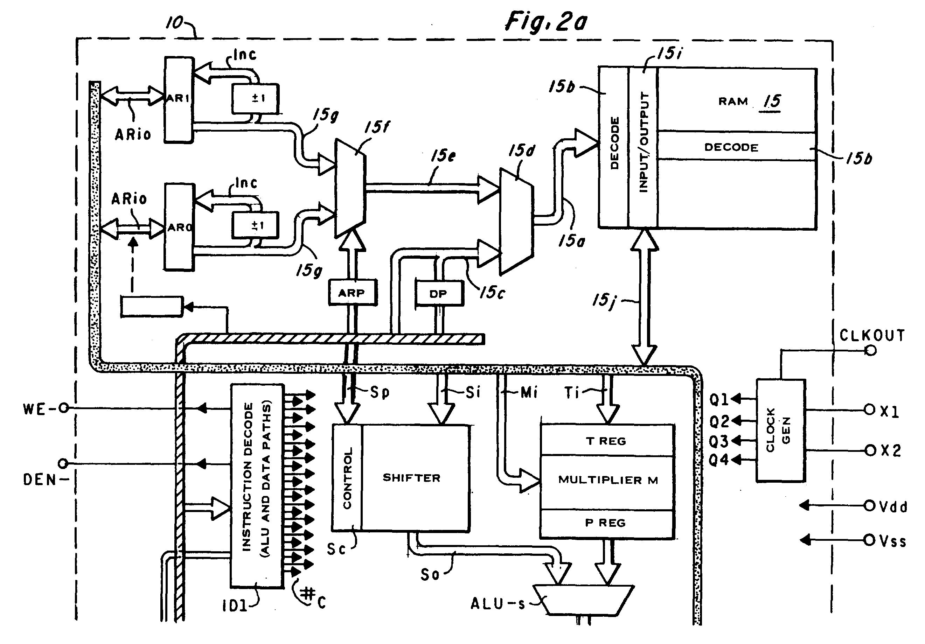

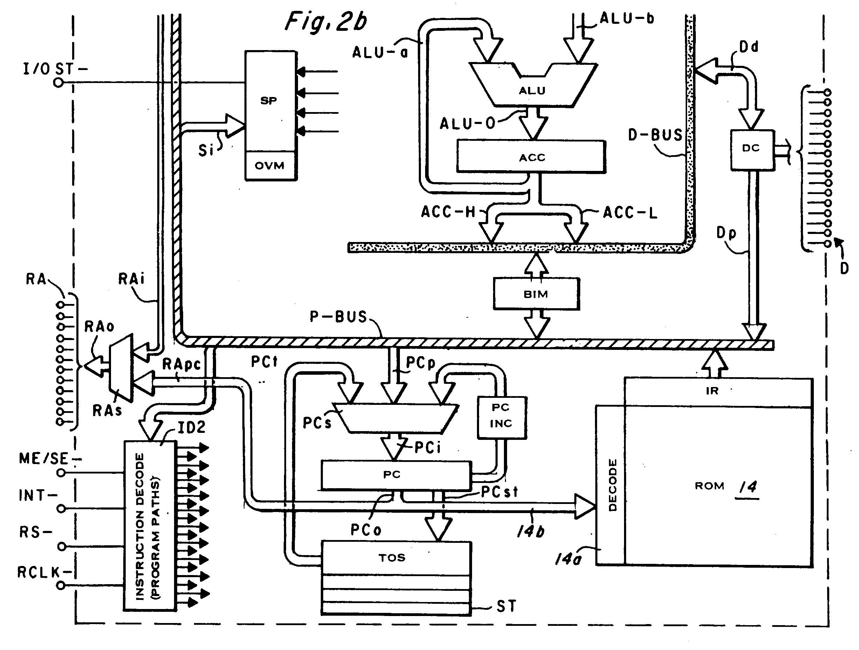

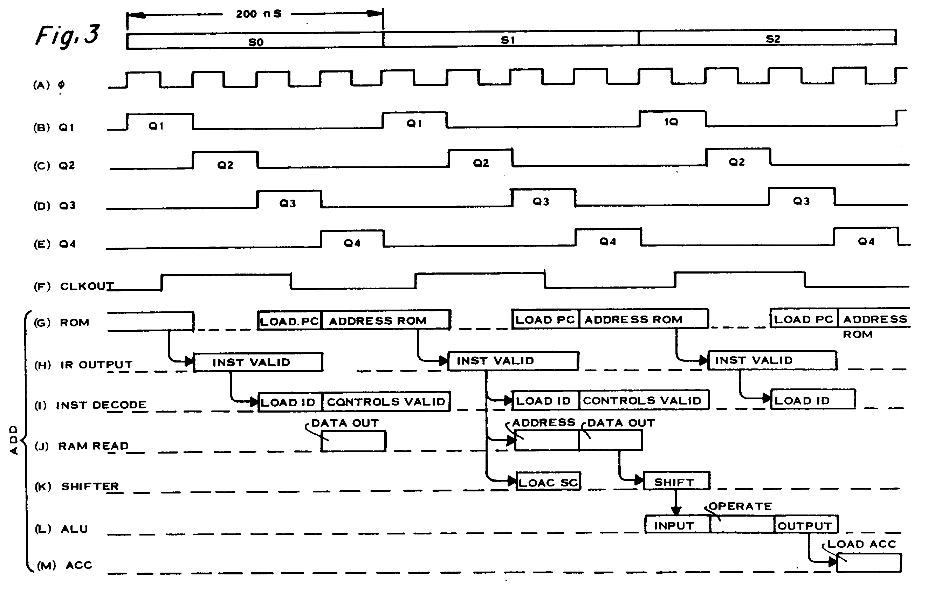

The article "A Microcomputer with Digital Signal Processing Capability" in Ig 82 IEEE International Solid-State Circuits Conference, Wednesday, February 10, 1982/Continental Ballrooms 5-9/11:15 AM./WAM 2.5, pages 32, 33, 284 and 285, discloses such a micro computer device as is shown in Figs. 2a and 2b of the patent specification.

In "Parallelism in Hardware and Software" by Harold Lorin there is described the overlapping execution of instructions (including instructions to load data) on a notional computer approximating to a CDC 6600 mainframe.

It is the principal object to this invention to provide improved features of a microcomputer device and system, particular one adapted for real-time digital signal processing or the like. Another object is to provide a high-speed microcomputer of enhanced capabilities.

According to the present invention there is provided a microcomputer device for digital signal processing formed on a semiconductor substrate and having data terminals, comprising: an arithmetic/logic unit having a data input and a data output; a data memory having an address input and having data input/output; a data bus coupled to the data input and data output of the arithmetic/logic unit, to the data input/output of the data memory and to said data terminals; a program memory having an address input, the program memory storing at least instruction words; a program address circuit coupled to the address input of the program memory; a program bus coupled to said program address circuit; a control circuit for generating control signals in response to instruction words to define the operation of said arithmetic/logic unit and transfer to and from the data bus; said control circuit including a timing circuit for generating clock voltages to establish operating cycles and to establish sub-cycles within each operating cycle; said program memory having an instruction output coupled to said program bus, and said control circuit including a portion coupled to said program bus; characterised in that during a single sub-cycle: the control circuit receives an instruction word defined by an address loaded into said program address circuit in a corresponding sub-cycle of a previous operating cycle from said program bus and provides control signals for addressing said data memory, and an address defining a next instruction is loaded into said program address circuit, said instruction on said program bus being provided by said instruction output of said program memory addressed during a previous sub-cycle; data from said memory being output to said data bus during a subsequent sub-cycle and input to said arithmetic/logic unit in a further subsequent sub-cycle and said output of said arithmetic/logic unit being valid during a corresponding sub-cycle of a next operating cycle during which an address of a yet further next instruction is loaded to said program address circuit and the next instruction is received by said control circuit.

In accordance with one embodiment, features of the invention are included in a system for real-time digital signal processing employing a single-chip microcomputer device having separate on-chip program ROM and data RAM, with separate address and data paths for program and data. An external program address bus allows off-chip program fetch in an expansion mode, with the opcode returned by an external data bus. A bus interchange module allows transfer between the separate internal program and data busses in special circumstances. The internal buses are 16-bit, while the ALU and accumulator are 32-bit. A multiplier circuit produces a single state 16x16 multiply function separate from the ALU, with 32-bit output to the ALU. One input to the ALU passes through a 0-to-15 bit shifter with sign extension.

### BRIEF DESCRIPTION OF THE DRAWINGS

The novel features believed characteristic of the invention are set forth in the appended claims. The invention itself, however, as well as other features and advantages thereof, will be best understood by reference to the detailed description which follows, read in conjunction with the accompanying drawings, wherein:
FIGURE 1 is an electrical diagram in block form of a microcomputer system employing features of the invention;
FIGURE 2 is an electrical diagram in block form of an MOS/LSI microcomputer device (including a CPU or central processor unit) employed in the system of Fig. 1 and utilizing features of the invention;
FIGURES 3a-3mm are timing diagrams showing voltage vs. time for clocks used in the microcomputer of Fig. 2.

### DETAILED DESCRIPTION OF SPECIFIC EMBODIMENT:

### MICROPROCESSOR SYSTEM

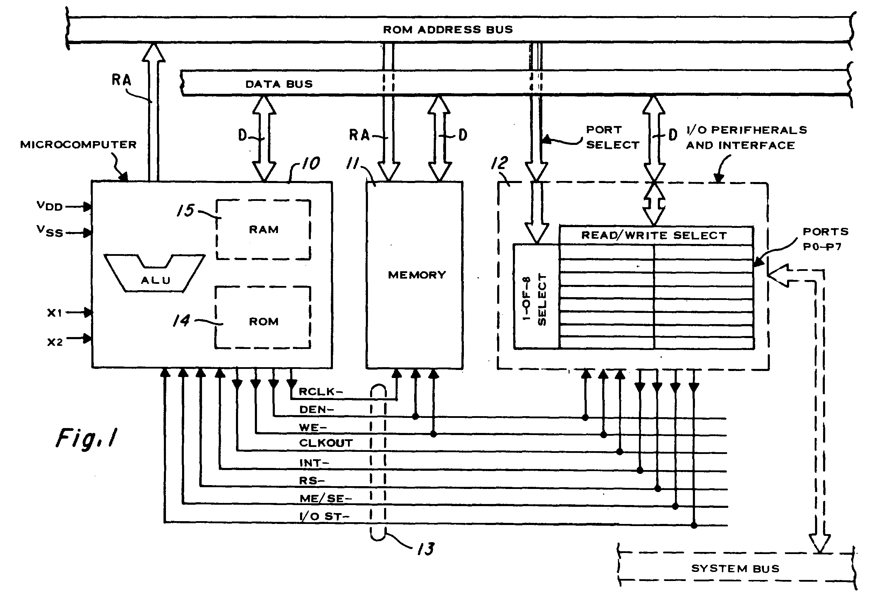

The microcomputer device to be described herein is primarily used for signal processing, but concepts thereof may be used in processor devices of various configurations, and these devices may be used in many different systems; in one embodiment the microcomputer is used in a system shown in generallized form in Figure 1. The system may be, for example, a voice communication system, a speech analysis system, a small "personal" or "home" computer, a single-board general purpose microcomputer, a word processing system, a computer terminal having local processing capability with display and typewriter keyboard, or any one of many applications of various types. The system includes a single-chip MOS/LSI central processing unit or microcomputer 10 which will be described in detail, along with a program or data memory 11 and input/output or I/O devices 12. Usually the I/O devices 12 for the typical system include analog-to-digital and/or digital-tc-analog converters, a modem, a keyboard, a CRT display, a disc drive, etc. Often the I/O 12 includes coupling to a general purpose processor; that is, the microcomputer 10 is an attached processor in a larger system with interface via the I/O 12. The microcomputer 10, program data memory 11 and I/O 12 communicate with one another by two multibit, parallel address and data busses, D and RA, along with a control bus 13. The microcomputer 10 has suitable supply voltage and crystal-input terminals; for example, the device employs a single +5V Vdd supply and ground or Vss, and a crystal is connected to terminals X1 and X2 of the device 10 to control certain system timing. The microcomputer 10 is a very high speed device with a crystal input of 20 MHz, providing an instruction execution rate of five million per second, in one embodiment.

The microcomputer device 10 is a general purpose microcomputer specifically aimed at serving a large class of serial signal processing problems such as digital filtering, signal handling for telecommunications modems (modulation, demodulation), data compression for linear predictive code (LPC) speech signals, fast Fourier transforms, and in general for virtually all computation intensive analog system functions, including detection, signal generation, mixing, phase tracking, angle measurement, feedback control, clock recovery, correlation, convolution, etc. It is suitable for applications which have computational requirements similar to those for control and signal processing, such as coordinate transformation, solution of linear differential equations with constant coefficients, averaging, etc. The device 10 is usually interfaced via I/O 12 to a general purpose processor such as a 99000, an 8600 or a 68000, to construct processing systems as will be explained.

It is understood that, even though described in the context of a microcomputer in the preferred embodiment, with an on-chip program ROM 14 and data RAM 15, neverthless some concepts of the invention may be used in a single-chip microprocessor with all off-chip program memory and/or data memory instead of the on-chip memory illustrated. Indeed, modes of operation are provided which disable the on-chip memory. Also, a microcomputer is shown having two separate external program address and data busses instead of the multiplexed, bidirectional busses which are now common, but some features herein disclosed are applicable where busses are multiplexed. The advantage of separating the busses and separating program and data memory space is speed.

In general terms, the system of Figure 1 functions in the following manner: the microcomputer 10 fetches an instruction word internally by accessing the ROM 14 or externally by sending out an address on the ROM address bus RA to the memory 11 (and RCLK- on control bus 13). If external, the instruction word is received back via the data bus D from the addressed location in the memory 11. This instruction is executed in the next machine cycle (of length of 200 ns defined by a 20 MHz clock or crystal X1, X2) while a new instruction is being fetched; execution of an instruction may include accessing the on-chip RAM 15 for an operand, or writing a result into data RAM 15, and an arithmetic or logic operation in ALU.

In the example to be described in detail, a 12-bit instruction address applied internally to ROM 14 or externally to the RA bus directly addresses 2¹² or 4K words of program instruction or constants in ROM 14 and memory 11. When reading from memory 11, a DEN- (data bus enable bar) command is asserted on control bus 13. It is also possible to write into the memory 11, and for this purpose a WE- (write enable bar) command is asserted by the device 10 on one of the control bus lines 13; the memory 11 may contain read/write memory devices in some or all of the address space, so the WE- command permits a write function.

The I/O devices 12 are addressed as ports; this interface to external devices 12 is accomplished using the address and data busses RA and D and control bus 13, but the I/O devices 12 do not occupy locations in the logical address space like the memory 11. This is in contrast to conventional memory-mapped I/O.

Data input/output via I/O or peripherals 12 employs a 3-bit field RAp from the bus RA to select one of eight 16-bit ports PO-P in peripheral circuitry 12. Each port can be defined as either input or output by DEN- or WE-, so in effect these are sixteen 16-bit parts, eight in and eight out. The selected 16-bit port is addressed by RAp and DEN- or WE-, then accessed for read or write via the bus D. This operation uses one of the two instructions IN or OUT; on the control bus 13, WE is active for write or OUT, or DEN- is active for read or IN. A ROM clock RCLKis active on control bus 13 on every machine cycle except when either DEN- or WE- is active; that is, the memory 11 is activated by RCLK- for possible instruction word access from off-chip in each machine cycle, but if accessing peripheral 12 using DEN- or WEthen the RCLK- does not occur.

A reset signal RS- on the control bus 13 clears the program counter and address bus RA (resets to zero), sets the data bus D in a high impedence state, and the memory controls DEN-, WE- and RCLK- in an inactive (high) state. All address and temporary data registers within the microcomputer 10 are cleared by a reset routine in the ROM 14, but the internal RAM is not cleared. In this manner, the peripheral circuitry 12 (such as a main processor) can assert control, or initiate a start-up or power-on sequence.

An interrupt signal INT- on the control bus 13 causes the microcomputer 10 to halt execution ( saving the current ROM address) and go to an interrupt vector address, unless interrupts are masked by the program.

The ME/SE- line in the control bus 13 defines the memory expansion mode or systems emulator node for the microcomputer 10. When this pin is held high (at +Vcc), the microcomputer executes from on-chip ROM and off-chip memory 11, but when low (Vss) the chip is in the systems emulator mode and execution is only from the memory 11 which is PROM, EPROM or RAM so the program can be easily changed.

### THE MICROCOMPUTER CHIP

The internal architecture of the microcomputer 10 is shown in a detailed block diagram in Figure 2. This device is a single-chip semiconductor integrated circuit mounted in a standard 40-pin dual-in-line package or a chip carrier. Sixteen pins or terminals of the package are needed for the 16-bit data bus D, twelve are used for the address bus RA and the remaining terminals are used for the power supply Vdd and Vss, the crystal X1, X2, and the control bus 13.

In addition to the program and data memory 14 and 15, the microcomputer 10 contains a central processing unit or CPU for the system of Figure 1, and this CPU includes a 32-bit arithmetic/logic unit or ALU, a 32-bit accumulator Acc to hold operands and results, multiplier M separate from the ALU, a shifter S which is one input to the ALU, status or flag decode SD, and an instruction decoder ID1 which receives the current instruction word and generates the control bits for the CPU and data memory portions of the device 10.

The program memory 14 has associated with it a program counter PC to hold the instruction address used to access the ROM 14 or sent out on bus RA to the memory 11, an instruction register IR to receive the instruction word from ROM 14, a stack ST to save program memory addresses, and an instruction decoder ID2 which receives the current instruction word and generates control bits for the program memory portion of the microcomputer. The instruction decoders ID1 and ID2 of course may be combined into one larger control ROM, or indeed split into smaller PLAs or random logic.

Associated with the data memory 15 are two auxiliary address registers AR0 and AR1 for the data memory 15, a page register ARP to select between the registers AR0 and AR1 for use as the data memory address, and a data page buffer DP to hold certain bits of the data memory address.

The CPU is oriented around two internal buses, a 16-bit program bus (P-Bus) and a 16-bit data bus (D-Bus). Program access and data access can thus occur simultaneously, and the address spaces are separate. The microcomputer is thus of the Harvard architecture, although a bus interchange module BIM permits loading the program counter PC from Acc, for example, or accessing ROM 14 for constants via P-Bus, BIM and D-Bus.

The two major requirements for a signal processing microcomputer are high speed arithmetic and flexibility. Performance is achieved by using separate, principally on-chip program and data memories 14 and 15, a large single accumulator Acc and a parallel multiplier M. A special purpose operation, data move, is defined within the data memory 15 which further enhances the performance in convolution operations. Flexibility has been achieved by defining an instruction set as will be described with reference to Table A, incorporating memory expansion and a single level of interrupt.

The device can be configured with, for example, less than 2K or 2¹¹ words of on-chip program memory 14 yet the architecture allows for memory expansion up to 4K or 2¹² words by the addition of external program memory in the memory 11. In addition, a separate mode allows the device 10 to be configured as a system emulation device; in this "system emulator" mode, the entire 4K memory space is external and the ROM 14 is not used.

### The CPU

The arithmetic/logic unit or ALU consists of thirty-two parallel stages, each separate stage performing an arithmetic or logic function on its two input bits and producing a one-bit output and carry/borrow. The particular function performed on data passing through the ALU is defined by the current 16-bit instruction word in IR which is applied by the program bus P-Bus to an instruction decoder ID1. The ALU has two 32-bit data inputs ALU-a and ALU-b, and a 32-bit data output ALU-o to accumulator Acc. The ALU-a input is always from the accumulator Acc and the ALU-b input is always either from the shifter S or from a 32-bit product register P in the multiplier M. The source of the ALU-b input is defined by an input select circuit ALU-s which selects from these two alternatives, based upon the contents of the current instruction word, i.e., the outputs #C of the decoder ID1. The shifter S receives a 16-bit input Si from D-Bus and produces a 32-bit output So which is the input Si shifted from zero to fifteen places to the left. Left-shifted data is zero-filled, i.e., all right-hand bit positions are filled with zeros when data is shifted out to the left. A unique feature is that the high-order bit is sign extended during shift operations. The ALU operates in twos-complement. The shifter S includes a shift control Sc loaded with a four-bit value from P-Bus via lines Sp so an arithmetic instruction can directly define the number of bits shifted in the path from D-Bus to the ALU-b input.

In this description, the LSB is considered to be on the right and the MSB on the left, so left-shift is toward more significant bits. Bit-0 is the MSB and bit-15 is the LSB. Data is usually handled in signed 2's complement in this architecture.

The multiplier M is a 16x16 multiplier using carry feed-forward, constructed in dynamic/static logic, to implement Booth's algorithm. One input to the multiplier M is the T register which is a 16-bit register for temporary storage of the multiplicand received from D-Bus via lines Ti. The other 16-bit input is via lines Mi from the D-Bus; this multiplier input may be from the data memory 15 or may be a 13-bit multiply-immediate value derived directly from the instruction word (loaded right-justified and sign-extended).

The ALU always receives the contents of the accumulator Acc as its ALU-a input, and always stores its output in Acc, i.e., Acc is always the destination and the primary operand. The unit will add, subtract and perform the logic operations of And, Or and Exclusive Or. The logic operation results are between the lower half of Acc (bits 16-31) and a 16-bit value from the data memory 15. Due to passing the data memory value through the shifter S (with zero shift), the operand for the logical operation result of the MSBs (bits 0-15) is zero. The final 32-bit result reaching the accumulator is thus in two parts: Bits 0-15 will be Acc bits 0-15 Anded (or Or'ed, etc) with zero; bits 16-31 of the result will be Acc bits 16-31 Anded (etc.) with the data memory value. The accumulator Acc output, in addition to the 32-bit ALU-a input, includes high and low 16-bit outputs Acc-H (bits 0-15) and Acc-L (bits 16-31); separate instructions SACH "store accumulator high" and SACL "store accumulator low" are provided for storing high and low-order Acc16-bit words in the data memory 15.

A status decoder SD monitors the Acc whenever an instruction which updates Acc is executed. Four bits of SD are OV, L, G and Z. Accumulator overflow (or underflow) is indicated by the OV bit, Acc contents less than zero is indicated by the L bit, Acc greater than zero indicated by the G bit, and Acc equal zero indicated by the Z bit. Upon interrupt the 0V bit is saved in an overflow flag register, but the other bits are available only up to the time the next accumulator instruction is executed.

The accumulator overflow mode is a single-bit mode register OVM (included in SD), directly under program control, to allow for saturated results in signal processing computations. When the overflow mode OVM is reset, overflow results are loaded via ALU-o into the accumulator Acc from the ALU without modification. When the overflow mode is set, overflow results are set to the largest, or smallest, representable value of the ALU and loaded into the accumulator Acc. The largest or smallest value is determined by the sign of the overflow bit. This allows a saturated Acc result in signal processing applications, modeling the saturation process of analog signals.

A separate status bit in SD monitors the condition of the currently used auxiliary register AR0 or AR1 and detects the all-zero condition of the least significant nine bits of the current auxiliary register (i.e. loop counter portion). This bit is used for a branch instruction conditioned on non-zero for the auxiliary register, BARNZ or "branch on auxiliary register non-zero."

The input/output status bit I/O ST- is an external pin which is part of the control bus 13 and provides "branch on I/O zero" instruction BIOZ to interrogate the condition of peripheral circuits 12. A zero level on the I/O ST- pin will cause a branch when sampled by the BIOZ instruction.

The bus interchange module BIM exchanges the low-order twelve bits of the 16-bit value on the D-Bus with the low-order twelve bits on the P-Bus. This operation is not available to the programmer as an instruction, but instead is needed as an inherent operation in instructions such as table look up TBLR A or table write TBLW, or in a cell-accumulator instruction CALLA where a completed address in Acc may be used to reach a subroutine. A 16-bit value from IR on the P-Bus may be loaded via BIM to D-Bus for storing in RAM is, for example, in table-read.

### Program Memory Addressing

The program memory 14 is a ROM which is partitioned X16 to produce a 16-bit output to instruction register IR, and this ROM employs a decoder 14a which selects one 16-bit instruction word based on an 11-bit or 12-bit address on input lines 14b. In the example embodiment, the ROM 14 contains less than 2K words, so an 11-bit address can be used, but the on-chip program memory could be expanded to 4K with a 12-bit address. The circuit of the ROM 14 is expecially adapted for fast access as will be explained. The address input 14b is received from the program counter PC which is a 12-bit register containing the address of the instruction following the one being executed. That is, at the time when the control bits #C are valid at the outputs of the instruction decoders ID1 and ID2 for one instruction; PC contains the address of the next instruction. After an address in PC goes into decoder 14a to read the next instruction from ROM 14 into IR, the program counter PC is incremented via PCinc in preparation for another instruction fetch; i.e. PC is self incrementing under control of a #C control bit from ID2. The output PCo from the program counter PC is also applied via lines RApc and selector RAs (and output buffers not shown) to the external RA bus via output lines RAo and twelve output pins of the microcomputer device. The RA bus (RAO through R-A11) contains the PC output via RApc when the selector RAs is in one mode, or contains the 3-bit port address input RAi when executing I/O instructions IN and OUT. Whenever the address in PC is above the highest address in ROM 14, off-chip program addressing to memory 11 is assumed; however, the device is designed to operate principally with the on-chip ROM 14, so for many uses of the device off-chip fetches for program instructions would never be needed. The program counter PC may be loaded via input PCi and selector PCs from the P-Bus for branch or call instructions, or loaded from the accumulator Acc via Acc-L, D-Bus, BIM, P-Bus, PCp and PCi in a "call accumulator" CALLA instruction or table-read and table-write.

The register stack ST is used for saving the contents of PC during subroutine and interrupt calls. In the illustrated embodiment, the stack ST contains four 12-bit registers constructed as a first-in, last-out push-down stack, although a larger or smaller number of registers could be used. The current contents of PC are saved by "pushing" onto the top-of-stack register TOS via lines PCst. Succesive CALL instructions will keep pushing the current contents of PC onto TOS as the prior contents are shifted down, so up to four nested subroutines can be accomodated. A subroutine is terminated by execution of a return instruction RET which "pops" the stack, returning the contents of TOS to PC via lines PCt, selector PCs and input PCi, allowing the program to continue from the point it had reached prior to the last call or interrupt. When TOS is popped, the addresses in lower registers of ST move up one position. Each subroutine, initiated by a call instruction or an interrupt, must be terminated by a RET instruction.

In an example embodiment, the ROM 14 contains 1536 words, so the remainder of the 4K program address space, 2560 words, is off-chip in the memory 11. When the memory expansion control pin ME/SE- is high, at logic 1, the device interprets any program address in PC in the 0-to 1535 range as being an on-chip address for the ROM 14, and any address in the 1536-4095 range as being an off-chip address so that the PC contents are sent out via RApc and RAo to the RA bus. An output strobe RCLK- generated by the decoder ID2 for every machine state enables the external memory 11 (except when IN or OUT instructions are being executed). When off-chip program memory 11 is accessed, the instruction word read from memory 11 is applied to the external bus D and thus to the internal P-Bus via input/output control DC and lines Dp; this is a 16-bit instruction and, like the output of ROM 14 via IR, it is loaded into decoders ID1 and ID2 for execution, or 12-bits are loaded into PC via PCp, or otherwise used just as an on-chip instruction fetch.

When the ME/SE- pin is at zero the device enters the system emulator mode wherein the entire 4K program address space is off-chip, so all PC addresses are applied to the RA bus via RApc and RAo. This mode is necessary when a user is developing systems or programs, prior to arriving at a final version of code for the ROM 14. That is, the microcomputer 10 can operate with no code permanently programmed into the ROM so that new programs (stored in RAM or EPROM in the memory 11) can be tested and debugged, then when the final code is extablished the chips 10 are produced in large volume with this code mask-programmed into the ROM 14.

In either mode, the first two program addresses 0000 and 0001 are used for the reset function. When the reset pin RS- is brought low, an address of all zeros is forced into the program counter PC, as will be explained. Also, the third address is reserved for an interrupt vector; when the INT- pin is brought low, an address of 0002 is forced into PC to begin an interrupt routine.

### Data Memory Addressing

The data memory 15 in the example embodiment contains 144 16-bit words, and so an 8-bit address is needed on address input 15a to the RAM address decoder 15b. However, the RAM 15 may be constructed with up to 512 words, requiring a 9-bit address, so the addressing arrangement will be described in terms of address bits which are unused in some embodiments. Each 128 word block of the RAM 15 is considered to be a page, so a 7-bit address field in an instruction word from program memory 14 on P-Bus via input 15c is used to directly address up to 128 words of data memory 15, within a page, and the page is selected by a data poage buffer DP. Alternatively, for indirect addressing; two auxiliary registers AR0 and AR1 are employed in the example embodiment; however, up to eight of these 16-bit auxiliary registers may be used, with the particular one currently being used as the source of the indirect address for the RAM 15 being defined by the auxiliary register pointer ARP. With two registers AR0 and AR1, the pointer ARP is only one bit, but for an embodiment with eight auxiliary registers the pointer ARP is a 3-bit register. The 16-bit auxiliary registers AR0 and AR1 are under control of indirect-address instructions, or store, load or modify auxiliary register instructions SAR, LAR, and MAR, as will be described. Nine-bit addresses from the low-order parts of the auxiliary registers may be applied to the address input 15a via selector 15d, lines 15e, selector 15f, and lines 15g, the paths being defined by control bits #C from ID1. When one of the auxiliary registers is to be the source of the RAM address, the selector 15d uses the value on lines 15e as the address input 15a, whereas if the P-Bus is to be the source of the RAM address the selector 15d uses a 7-bit address from input 15c and a 1-bit (expandable to 3-bit or 4-bit) page address from the data page register DP. The selector 15f is controlled by the pointer ARP which is loaded from P-Bus as defined by an instruction. The auxiliary registers are used for indirect addressing wherein an instruction need not contain a complete address for RAM 15 but instead merely specifies that an auxiliary register is to be used for this address; such instructions can also specify increment or decrement for the auxiliary register selected, in which case the nine LSBs of AR0 or AR1 are changed by +1 or -1 via paths Inc. The auxiliary registers may be thus used as loop counters. The auxiliary registers are accessed by the D-Bus via lines ARio so these registers may be used as miscellaneous working registers, or may be initially loaded to begin a loop count.

The data memory 15 is accessed using the D-Bus and an input/output circuit 15i, via lines 15j. Construction of the data memory is such that a data move wholly within the RAM 15 is permitted, according to an important feature of the microcomputer 10. Under instruction control, the data at one address can be moved to the next higher location within one machine cycle without using the ALU or D-Bus. Thus during an add, for example, the accessed data can be also moved to the next higher address.

### Input/Output Functions

Input and output of data from the microcomputer chip 10 uses the data bus D and two of the lines of the control bus 13, these being data enable bar DE- and write enable bar WE-. Two instructions, IN and OUT, are employed for the data input and output functions. The external data bus D is coupled to the internal data bus D-Bus by the input/output control and data buffers DC and lines D1. The output buffers in DC are tri-state, so the output to data bus D from DC is always placed in a high impedence state except when OUT is being executed; to this end, one of the controls #C from the instruction decode ID1 sets the output buffers in high impdence state whenever OUT is not decoded. When the instruction IN is present, the control DC activates sixteen input buffers, so the external data bus D is coupled to the internal D-Bus via DC and lines Dd for data input. When the OUT instruction is decoded, a control #C from ID1 activates output buffers in DC so the internal D-Bus is coupled via Dd and DC to the external bus D.

Execution of an IN instructions will also generate a data enable DEN- strobe on line 13a from ID1, and will couple the D-Bus to the RAM 15 via 15i and 15j, so the data from external will be entered into on-chip data memory. The intended uses of the microcomputer as a signal processor require hundreds or thousands of accesses to RAM 15 for every off-chip reference. That is, a value will be fetched from off-chip then convolution or like operations performed using this new value and other data in the RAM 15, so thousands of instruction executions will transpire before another off-chip reference is needed. For this reason, the architecture favors internal data manipulation over off-chip data access.

Execution of an OUT instruction causes generation of an off-chip write enable WE- strobe on line 13b from ID1 and outputs data from RAM 15 via 15i and 15j, D-Bus, lines Dd and buffer DC to the external bus D. Referring to Fig. 1, this data may be written into one of the ports PO-P7 (selected by the 3-bit RAi value) in the peripherals 12.

Implicit in both the IN and OUT instructions is a 3-bit port address on lines RAi from ID1. This address is multiplexed onto the three LSBs (RA9-RA11) of the external address bus RA via selector RAs. Up to eight peripherals may thus be addressed. The remaining high order bits of the RA bus outputs are held at logic zero during these instructions.

### THE INSTRUCTION SET

The microcomputer 10 of Figs 1 and 2 executes the instruction set of Table A. The Table shows in the first column the mneumonic or assembly language name of each instruction used in writing source code, followed in the second column by the object code in binary which is the form the code appears in the ROM 14 and in the instruction register IR. This binary code is decoded in ID1 and ID2 to generate all of the controls #C to execute the desired operation by accessing various busses and registers and setting the functions of the ALU. The Table also gives the number of cycles or machine states employed by the microcomputer in executing the instruction; note that all instructions except branches, calls, table look-up and input/output are executed in one state time. The microcomputer is not microcoded; the standard ALU instructions are executed in one state. The Table also shows the number of instruction words or opcodes needed to define each instruction; it is important to note that only branches and call direct require two instruction words. The right-hand column of Table A is a brief description of the operation for each instruction.

Most of the instructions of Table A show the low-order eight bits (bits 8-15) as "IAAAAAAA", which is the direct or indirect RAM 15 address for one operand. If the "I" bit, bit-8, is 0, the direct addressing mode is used, so the "A" field of the instruction word, bits 9-15, is employed as a direct address connected from IR through P-Bus, lines 15c and selector 15d to address input 15a. In this direct addressing mode, the auxiliary registers AR0-AR1 are not used.

For the instructions containing "IAAAAAA", the indirect addressing mode is specified by a 1 in the I field, bit-8, of these instructions. The input address on lines 15a for the RAM 15 will in this case be obtained from one of the auxiliary registers AR0 or AR1, and bit 15 will select which one. If bit-15 is 0, AR0 is used; if bit-15 is 1, AR1 is used. Thus bit-15 coupled from IR via P-Bus controls the selector 15f (and can be loaded into the ARP register). Since the number of auxiliary registers is expandable to eight, bits 13-15 of these indirect-address instructions are reserved for use with a 3-bit selector 15f and ARP register to define one-of-eight in the indirect addressing mode. Bit-10 to bit-12 are controls in indirect addressing: bit-10 causes the addressed auxiliary register to be incremented if 1, or no change if 0; bit-11 causes the addressed AR to be decremented if 1 or no change if 0; bit-12 if 0 causes bit-15 to be loaded into ARP after execution of the current instruction, or if 1 leaves the ARP unchanged.

The shift code SSSS used in several instructions of Table A is a four-bit field loaded into shift control Sc via Sp to define the number of spaces (zero to fifteen) that the data coming from the RAM 15 via D-Bus is left shifted as it passes through the shifter S on the way to the ALU-b input.

Although not material to the structure described herein, assembly language formats using the instruction set of Table A employ, "A" to designate direct addressing and "@" to designate indirect. Thus, "ADD S,A" means add contents of memory location defined by the A field of the instruction word. "ADD A@" means add using contents of the data memory location addressed by the auxiliary register AR0 or AR1 selected by the existing contents of ARP. ADD S@+ means add using current contents of ARP to define AR then increment this auxiliary register for loop counting; ADD S@ is the same as previous except decrement by 1. ADD S@-, AR is same as previous except ARP is loaded with the value of bit-15 to define a new auxiliary register for subsequent operations.

The descriptions given in the right-hand column of Table A assume direct addressing . For indirect addressing, the above explanation applies.

The ADD instruction thus adds the 16-bit contents of RAM 15 (at location OAAAAAAA for direct, or the contents at the locations in RAM 15 selected by the chosen AR if indirect), shifted SSSS spaces left, to the 32-bit contents of the Acc, and stores the result in the Acc. ADDH does the same except only the high-order half of Acc is the source of one operand and destination of the result, and no shift is performed.

The subtract instructions SUB and SUBH subtract the addressed RAM 15 data from the accumulator and store the result in Acc, but are otherwise the same as add. The load instruction LAC loads Acc with the 16-bit data addressed by IAAAAAAA which is left-shifted by SSSS bits. Only ADD, SUB and LAC specify a shift.

There are four instructions associated with the auxiliary registers: SAR, LAR, LARK and MAR. Store auxiliary register SAR causes the contents of one of the auxiliary registers defined by RRR to be stored in the memory location IAAAAAAA; the load AR instruction LAR is the reverse of SAR. The AR selected in SAR or LAR is defined by a pointer RP loaded from P-Bus with the RRR field of the instruction word, determining which of the auxiliary registers is coupled to D-Bus via lines ARio. With the LARK instruction a constant K from IR (bits 8-15) is loaded into the AR defined by RRR; this 8-bit constant K is right-justified and MSBs set to zero in the 16-bit auxiliary register. The modify auxiliary instruction MAR causes one auxiliary register to be modified by bit-10 to bit-12 as above, but no add or access to memory 15 access is implemented. The MAR code is operative only in the indirect mode, I=1; in direct mode this instruction results in no-op.

The input/output instructions are written in assembly language as "IN PA, A" or "OUT PA, A" , where PA is the 3-bit port address PPP output on bits 9-11 of the RA bus(generated from the decoder ID1 and coupled via lines RAi). IN enables DEN- and disables RCLK-, while OUT enables WE- and disables RCLK-. The peripheral devices 12 decode RA9-RA11 to select one of eight 16-bit ports P0-P7, locations for read or write via the bus D. These instructions use two machine states so that the data input pins of bus D are free on the second state to allow external fetch of the next instruction from memory 11 instead of ROM 14.

The store accumulator instructions SACL and SACH, written as "SACL X,A" in assembly, cause the low or high order bits of Acc to be left-shifted XXX places and stored in the data memory 15 at the location defined direct or indirect by IAAAAAAA. The X field is not fully implemented in the example embodiment; for SACH only X=0, X=1 and X=4 are allowed. This shift is implemented in the accumulator Acc circuitry itself rather than in the shifter S or in ALU.

The arithmetic and logic instructions without shift code are ADDH, ADDS, SUBH, SUBS, SUBC, ZALH, ZALS, EXOR, AND, OR and LACK. These are all written as ADDH A, for example, in assembly language. ADDH causes the 16-bit data from the defined location in RAM 15 to be added to the high-order half of Acc and stored in the high-order half of Acc; actually the data from RAM 15 is left shifted sixteen bits in shifter S as it goes from D-Bus to the ALU-b input . The ADDS instruction means that the sign extension is suppressed in the shifter S; the data from RAM 15 defined by A is treated as a 16-bit positive number instead of a signed 2's complement integer. SUBH and SUBS correspond to ADDH and ADDS except subtract is performed in the ALU.

The conditional subtract instruction SUBC is used in divide operations. The contents of the defined location in RAM 15 are subtracted from the contents of Acc and left-shifted fifteen bits, producing an ALU output ALU-o which, if equal to zero is left-shifted by one bit and a +1 is added, with the result stored in Acc. If the ALU output is not equal to zero then it is left-shifted by one-bit and stored in Acc (the +1 is not added). SUBC is a two-cycle instruction that assumes the accumulator is not used in the following instruction. If the following operation involves Acc then a NO OP instruction should be inserted after SUBC.

The "xero accumulator load high" instruction ZALH fetches the 16-bit word at the addressed location in the RAM and loads it into the high-order half of Acc (bits 0-15); the Acc has been zeroed, so the low-order bits 16-31 remain zero. The shifter S is in the data path from D-Bus via ALU to Acc, so a 16-bit shift is performed in ZALH to move the data to the high-order half. The ZALS instruction fetches a word from RAM and loads it into the low-order half of the zeroed Acc, with sign extension suppressed in the shifter S.

The logic operations EXOR, AND and OR are performed in 32-bit format, even though the operand fetched is sixteen bits. For EXOR, the high-order half of Acc is Exclusive Or'ed with zeros, concatenated with Exclusive Or of the fetched data with the low-order half of Acc, both halves of the result being stored in Acc. The same applies to OR and AND.

The load accumulator instruction LACK causes an 8-bit constant contained in the eight LSB's of the instruction word to be ioaded into the eight LSB's of Acc, right justified; the upper twenty-four bits of Acc are zeroed. To accomplish this operation, the instruction word on P-Bus from IR (after ID1 and ID2 are loaded, of course), is coupled to the D-Bus by BIM, and thence to the ALU-b via shifter S (with no shift). The ALU performs "pass ALU-b" or add zeros to b, leaving the constant in Acc.

The data shift or data move instruction DSHT causes the contents of the defined location in the RAM 15 to be moved to the defined location plus one. This is accomplished internal to the RAM 15 without using the ALU or data bus D-Bus. The operation cannot cross a page boundary, however.

The "load T" instructions are used to set up multiply operations. LT causes the T register to be loaded from RAM 15 with the value defined by IAAAAAAA. The "load T with data move" instruction LTD employs an operation like DSHT in the RAM; the T register is loaded with the contents of the RAM 15 location defined by IAAAAAAA, then this same value is shifted to location IAAAAAAA + 1, and also the contents of Acc is added in ALU to the contents of the P register with the result going to Acc. The LTA instruction is the same as LTD but without data move; the T register is loaded from RAM 15 and the P register is added to Acc, with result to Acc.

The multiply instruction MPY causes the 16-bit contents of T register to be multiplied in multiplier M (not using ALU) by the value from RAM 15 on the input Mi from D-Bus, with the 32-bit result going to the P register. The "multiply constant" instruction MPYK causes the 16-bit contents of T register to be multiplied by a 13-bit constant C from the opcode in IR; the 32-bit result stays in P register. For MPYK, the constant is connected from IR to Mi via P-Bus, BIM and D-Bus.

The "load data page" instructions LDPK and LDP cause the data page register DP to be loaded with up to eight bits from the opcode itself or from the defined location in RAM 15. In the embodiment shown, the DP register is only one bit, but in other embodiments with a larger RAM 15 the DP register contains up to eight bits. The page address remains the same in DP until a new load page instruction occurs.

The load status and store status instructions LST and SST are used in call subroutine or interrupts to save the contents of the status circuits SD, or restore status SD. These instructions are used instead of hard wired circuits for performing this function.

The disable and enable interrupt instructions DINT and EINT are used to mask or unmask the interrupt capability, i.e., these instructions reset or set a latch which determines whether or not the microcomputer 10 responds to the INT- pin.

An absolute value instruction ABS functions to assure that the accumulator contains only an absolute valve, i.e., if Acc is less than zero, the absolute value of Acc is loaded into Acc, but if Acc is greater than zero there is no change. Similarly, the zero accumulator instruction ZAC clears Acc.

The overflow mode instructions RAMV and SAMV cause the overflow mode latch OVM in the status decode SD to be set to 1 or reset to 0. When OVM is set, the ALU output is set to its maximum or minimum before loading into Acc upon overflow. This simulates the effect of saturating an amplifier in an analog circuit, and is useful in signal processing.

Three P register instructions PAC, HPAC and SPAC are used in manipulating data after a multiply MPY or MPYK. PAC loads the accumulator with the contents of the P register by passing the 32-bit data through the ALU without performing any operation to modify the data; actually the ALU-a input is zeroed and an Add is executed. The APAC instruction adds the contents of the P register to the contents of Acc, with the result going to Acc. Similarly, the SPAC subtracts the contents of P register from Acc, result to Acc.

The subroutine instructions are CALL, CALLA and RET. CALL is a two-word instruction; the first word is the opcode and the second is the absolute address of the first instruction in the subroutine. When CALL is decoded in ID2, PC is incremented to fetch the next instruction word which is the address, then the incremented contents of PC are pushed to stack ST. The subroutine ends in return RET which causes the address on TOS to be popped and loaded into PC. To save status, SST must be used before CALL, and LST inserted after RET. The CALLA instruction is unique for a Harvard architecture machine; this uses the contents of Acc as the subroutine address rather than using the next location addressed by PC+1. The low-order bits of Acc are transferred via Acc-L and BIM to the P-Bus and thus via PCp to the program counter PC. The incremented PC is saved in CALLA by pushing to ST just as in a CALL.

The table look up instructions TBLR and TBLW also employ the Acc as an address source. These instructions require three states to execute. The RAM 15 location defined by IAAAAAAA is transferred via D-Bus and BIM to P-Bus, and thus via PCp to PC, from whence this address is applied to ROM 14 or via RApc to the external RA bus.

The branch instructions all require two words, the first being the opcode and the second at PC+1 being the address. The low-order bits 8-15 of the branch opcodes are unused. Unconditional branch B loads the word at PC+1 into PC as the next address. BARNZ is conditional upon whether or not a loop counter, one of the auxiliary registers defined by ARP, is not-zero. BV causes a branch if the overflow bit OV in the status decode SD is a 1. BIOZ causes a branch if the IO bit from I/O ST- is active-low, corresponding to a 1 in the status decoder SD. The six instructions BLZ, BLEZ, BGZ, BGEZ, BNZ and BZ are all dependent upon the defined condition in SD reflecting the condition in Acc.

### SYSTEM TIMING

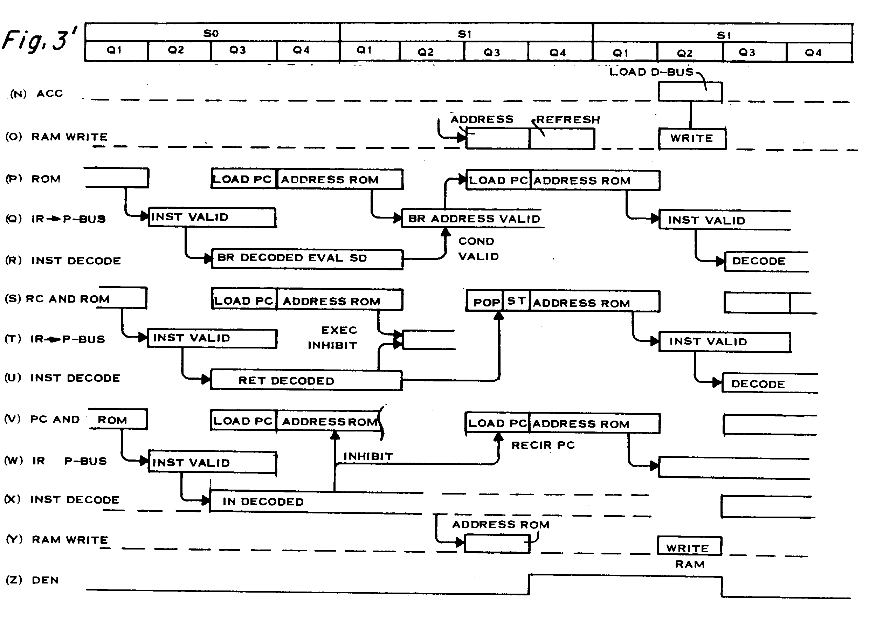

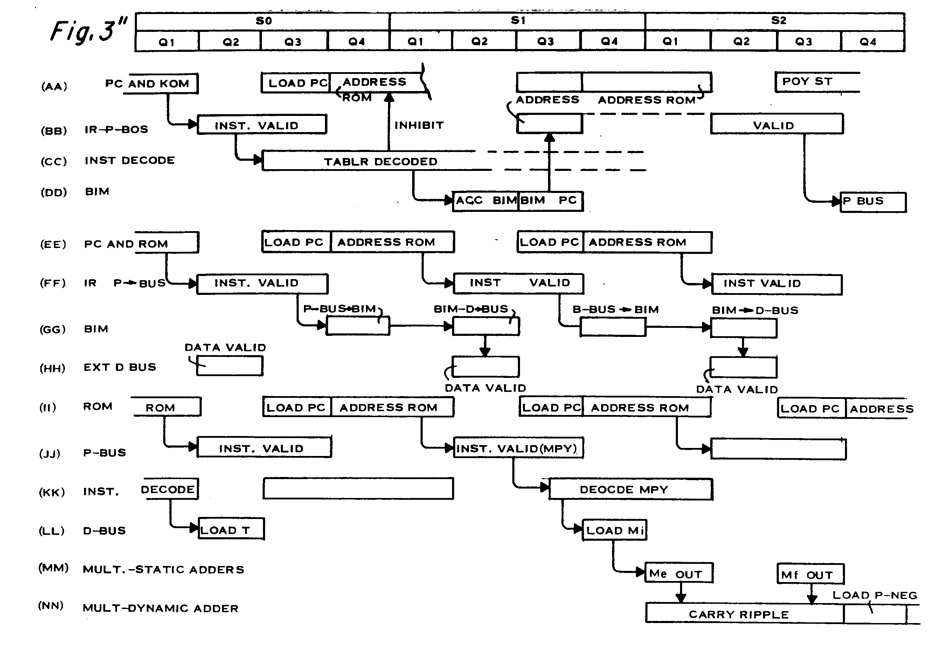

Referring to Fig. 3a et seq the timing of the system of Fig. 1 and the CPU chip of Fig. 2 is illustrated in a sequence of voltage vs. time waveforms or event vs. time diagrams. The chip 10 includes a clock generator 17 which has two external pins X1 and X2 to which a crystal (or external generator) is connected. The basic crystal frequency is up to 20 MHz and is represented by a clock Φ of Fig. 3a. This clock Φ has a period of 50ns, minimum, and is used to generate four quarter-cycle clocks Q1, Q2, Q3 and Q4 seen in Figure 3b-3e, providing the basic internal timing for the microcomputer chip 10. A set of four quarter cycle clocks Q1 to Q4 defines one machine state time of 200ns, minimum; the states are referred to as S0, S1, S2, in Fig. 3. The clock generator 17 produces an output CLKOUT, Fig.3f, on one of the control bus lines 13. CLKOUT has the same period as Q1, but 50% duty cycle and beginning at the midpoint of Q1. This output is used for timing or synchronizing external elements of the system of Fig. 1.

Internally, the microcomputer 10 executes one instruction per state time for most types of instructions, so five million instructions per second are executedat 20 MHz clock rate. Of course, some instructions such as input/output, branch, call or table look-up require two or three state times. Assuming a sequence of single-state instructions such as add, load, store, etc., a new address is loaded into PC during each Q3 as seen in Fig. 3g, then the ROM 14 is addressed during Q4 and Q1 so an instruction word output is produced from IR onto P-Bus valid in the next Q2 and continuing through Q3, as seen in Fig. 3h. The ROM 14 access time is thus about 100ns. If an external instruction fetch from memory 11 is used, the same access time applies. The instruction decoders ID1 and ID2 receive the instruction word from P-Bus during Q3 as seen in Fig. 3i, and most of the decoder outputs #C are valid during Q1, although some fast controls are available in Q4. For direct addressing of the RAM , the address on bit-9 to bit-15 of P-Bus is immediately gated into the RAM decoder 15b when P-Bus becomes valid, but in either direct or indirect the RAM address is valid by the beginning of Q3 as seen in Fig. 3j. For RAM read, the data output via 15j to D-Bus is valid on Q4, Fig. 3j, and this data passes through the shifter S, Fig. 3k, and is available as an ALU input during Q1, Fig. 31. The ALU controls #C are valid in Q2 and the ALU output ALU-o is available during Q3. The accumulator Acc is loaded from ALU in Q4, Fig. 3m, then saturated in the next Q1.

It is thus seen that an ADD instruction, for example, for which fetch began at Q3 of the S0 state in Fig. 3a-3m, will be completed, i.e., the result loaded into Acc, in Q4 of state S2, then the saturated Acc available in Q1 of state S3 could be loaded to D-Bus in Q2. There is substantial overlap of instruction execution. A new instruction fetch begins during Q3 of each state time for one-state instructions, so execution of two more instructions may have begun before one is finished.

Not shown in Fig. 3a-3m is the write-RAM function. The RAM 15 is always written into during Q2. Addressing the RAM is always during Q3, however. Thus, an instruction such as "store accumulator low" SACL is illustrated in Figs 3n and 30. The RAM address is received from the instruction register via P-Bus on Q3 of S1 (assuming the SACL instruction was fetched beginning at Q3 of S0), and the write will not occur until Q2 of state S2. During the read slot, Q4 of S1, a refresh occurs for the addressed row of the RAM, then the same address stays until Q2 of state S2 for the write. The D-Bus is loaded from Acc during this same Q2, see Fig. 3n.

If the accumulator must perform the saturate function in the overflow mode, i.e., OVM set to 1, this will be performed after the load accumulator function of Fig. 3m. That is, for the ADD instruction of Figs. 3a-3m, the Acc is saturated during Q1 if the next state S3, so that when the accumulator is accessed by the following instruction it will be available to load the D-Bus on Q2.

When an instruction uses the data move function within the RAM 15, the move operation occurs during Q1 as illustrated in Fig. 30. Also, if the increment loop counter function is performed for the auxiliary registers AR0 or AR1, the increment (or decrement) is executed in Q1. The T register, auxiliary registers AR0 or AR1, ARP latch, DP register and stack ST registers are each loaded during Q2 of any state time if these functions are included in the current instruction.

The bus interchange module BIM always executes a transfer from D-Bus to P-Bus beginning in Q2, if this function is defined by the instruction. The transfer from P-Bus to D-Bus by BIM is begun during Q4. The D-Bus is precharged on Q3 of every cycle, so no data can carry over on D-Bus through Q3 of any state, nor can data be loaded to or from D-Bus during Q3.

The program counter PC is incremented by the PCinc path during Q3 of each state time. That is, the load PC function of Fig. 3g is the incremented value just generated.

Execution of a branch instruction is illustrated in Fig. 3p-3r. If the instruction loaded into the decoders ID1 and ID2 during Q3 of state S0 is a branch, the status decode SD bits from the previous instruction are valid during Q1 of S1 so the decision of branch or not is made at this point. Meanwhile, of course, another instruction fetch has begun so if the branch condition is met the instruction delivered to P-Bus during Q2 of S1 is used as the next address but not executed, i.e., not loaded to ID1 and ID2; if the condition is not met, however, this instruction is discarded i.e., stays in P-Bus until precharge. Assuming the condition is met, the branch address is loaded from IR via P-Bus to PC during Q3 of S1, and the new instruction delivered to IR and P-Bus in Q2 of S2 then decoded and executed beginning at Q3 of S2, Fig. 3r.

A CALL instruction is executed in the same time sequence as a branch, seen in Fig. 3p-3r, except no SD evaluation is needed, and the original PC+1 is pushed to stack ST during Q3 of S1.

A return instruction RET is a two cycle instruction as illustrated in Fig. 3s-3u. If the instruction loaded into the decoders ID1 and ID2 during Q3 of state S0 is RET, the instruction fetch which began with PC "increment and load PC" in Q3 of S1 is discarded and a pop stack function is performed in Q3 of S1 so the next instruction fetch is to the return address. The instruction fetched during Q4 of S1 is then decoded and executed beginning at Q3 of S2.

Input (or output) instructions are executed in two cycles as illustrated in Figs. 3v-3z. Assume the opcode loaded into the decoder ID2 in Q3 of S0 is IN, seen in Fig. 3x. The instruction fetched beginning at Q3 of S0 is not used; execution is inhibited by the decode of IN so it is never loaded from IR to P-Bus. The contents of PC at Q3 of S1 are saved until Q3 of S2 for the next instruction fetch; that is, PC is recirculated back to PC by the increment path, but no increment is performed. The controls #C produced from decode of IN are available for two states. The RAM address is loaded from P-Bus on Q3 of S1, seen in Fig. 3y, and the data input reaches D-Bus on Q4 of S1 and is written into RAM 15 during Q2 of S2. The DEN- control is active from Q4 of S1 through Q2 of S2 for the IN function. An OUT instruction is executed like IN except the RAM 15 is read during Q4 of S1 and the WEcontrol is active instead of DEN-.

A table look up instruction is executed as shown in Fig. 3aa-3dd. The TBLR opcode is decoded beginning at Q3 of S0 and causes the Acc to be copied via D-Bus to BIM in Q2 of S1, then PC is loaded with this Acc value via P-Bus from BIM in Q3 of S1 so the content of Acc is used as the next instruction fetch address. Meanwhile, execution of the instruction fetched beginning at Q3 of S0 is inhibited by preventing a ROM read control #NRIR from copying IR to P-Bus (the ROM 14 output), at Q2 of S1. The incremented contents of PC from Q3 of S0 are pushed to ST during Q3 of S1, then popped at Q3 of S2 as the following instruction address. The data fetched from ROM 14 (or memory 11) using the address from Acc during Q4/S1 to Q1/S2 is loaded onto P-Bus during Q2 of S2 where it remains until Q4 of S2 at which time the BIM accepts the data from P-Bus and then transfers it to D-Bus on Q2 of 53, the next state. The destination address for RAM 15 is loaded into decoder 15b from P-Bus by Q3 of S1 and remains for two states, so the RAM write occurring at Q2 of S3 will use the RAM address defined in the original TBLR opcode.

One of the problems inherent in manufacturing microcomputer devices is that of testing the parts to determine whether or not all of the elements are functional. In many microcomputers, the instruction words read from the internal ROM are not available on external busses and so the ROM cannot be checked in any way other than by executing all possible functions, which can be lengthy. The device of Fig. 2 allows the ROM 14 to be read out one word at a time using the bus interchange module as illustrated in Figs. 3ee-3hh. A test mode, not part of the instruction set of Table A, is entered by holding the I/O ST- pin at above Vdd, for example 10V, and holding RSlow, producing an input to the decoders ID1 and ID2 causing a ROM output function in which the ROM 14 is accessed every cycle and PC incremented as seen in Fig. 3ee. The P-Bus receives the ROM output, Fig. 3ff, but the opcodes are not loaded into the decoders ID1, ID2. Instead, the BIM accepts the opcodes from P-Bus on Q4 of each cycle and transfers to D-Bus on the next Q2, as seen in Fig. 3hh.

### Bus Interchange Module

The bus interchange module BIM, shown in detail in Fig. 4a, consists of sixteen identical stages, only one of which is illustrated. Each stage has two clocked inverters Ia, with no feedback loop since data is not held in BIM longer than about half a state time. Input node Ib is connected to the respective bit of P-Bus via one of sixteen transistors Ic driven by a control bit #BIFP valid on Q4. The D-Bus is connected to the input node Ib via transistors Id driven by the control bit #BIFD (Bus Interchange From D) from decoder ID1 valid on Q2. The output node Ie is connected to the P-Bus by a push-pull stage including transistors If and Ig, and a transistor Ih driven by a control bit #BITP, valid during Q2 and Q3. Likewise, output node Ie is coupled to the D-Bus via a push-pull stage having driver transistors Ii and Ij, and a transistor Ik driven by a control bit #BITD valid on Q2 and Q4. The transistors Ig and Ij are driven by node Im at the output of the first inverter Ia, providing a push-pull output. Data is transferred from D-Bus to nodes Ib, Im, Ie on Q2, and then from these nodes to P-Bus on Q4. Simularly, data is transferred from P-Bus to nodes Ib, Im, Ie on Q4, and then from these nodes to D-Bus on Q4 or the next Q2.

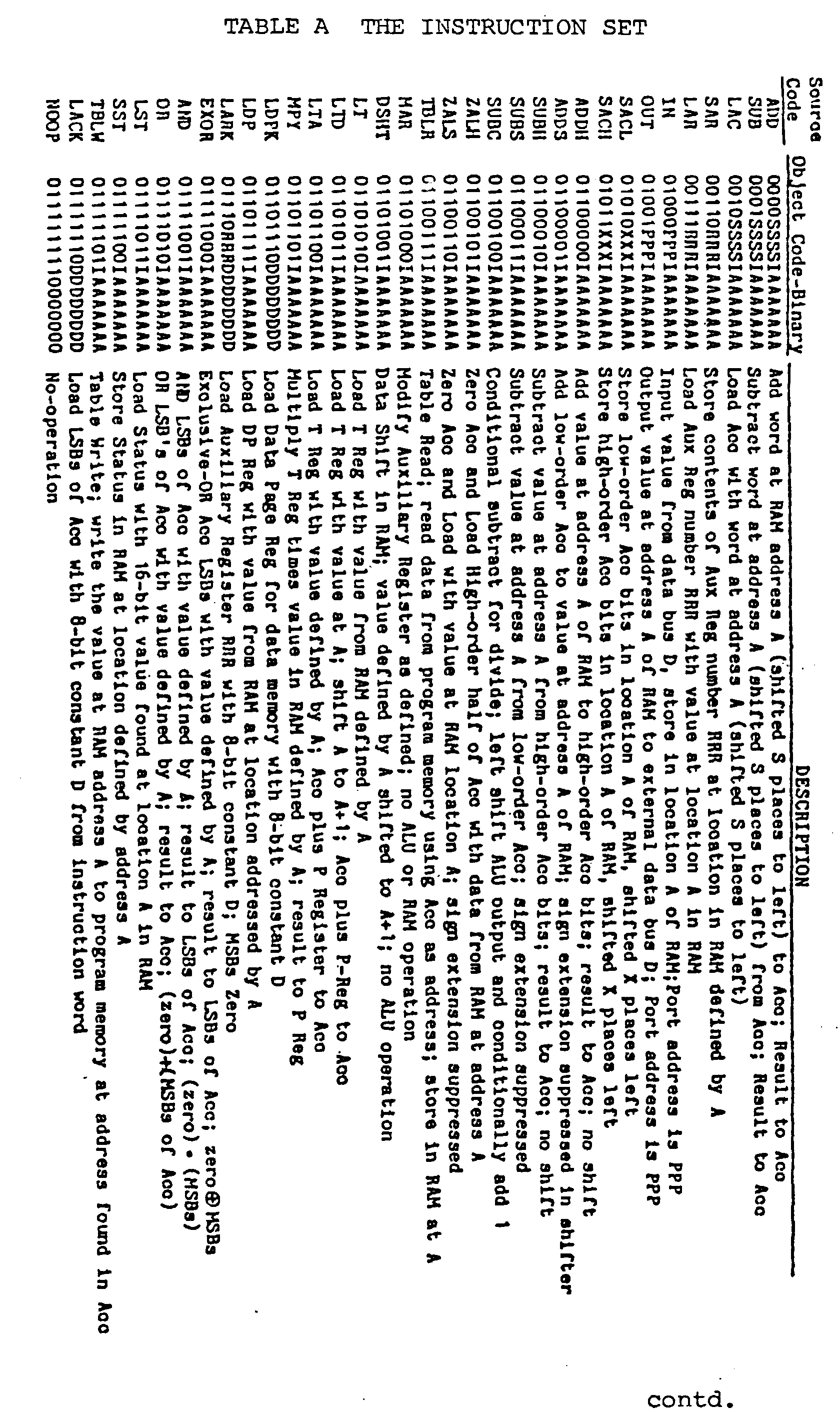

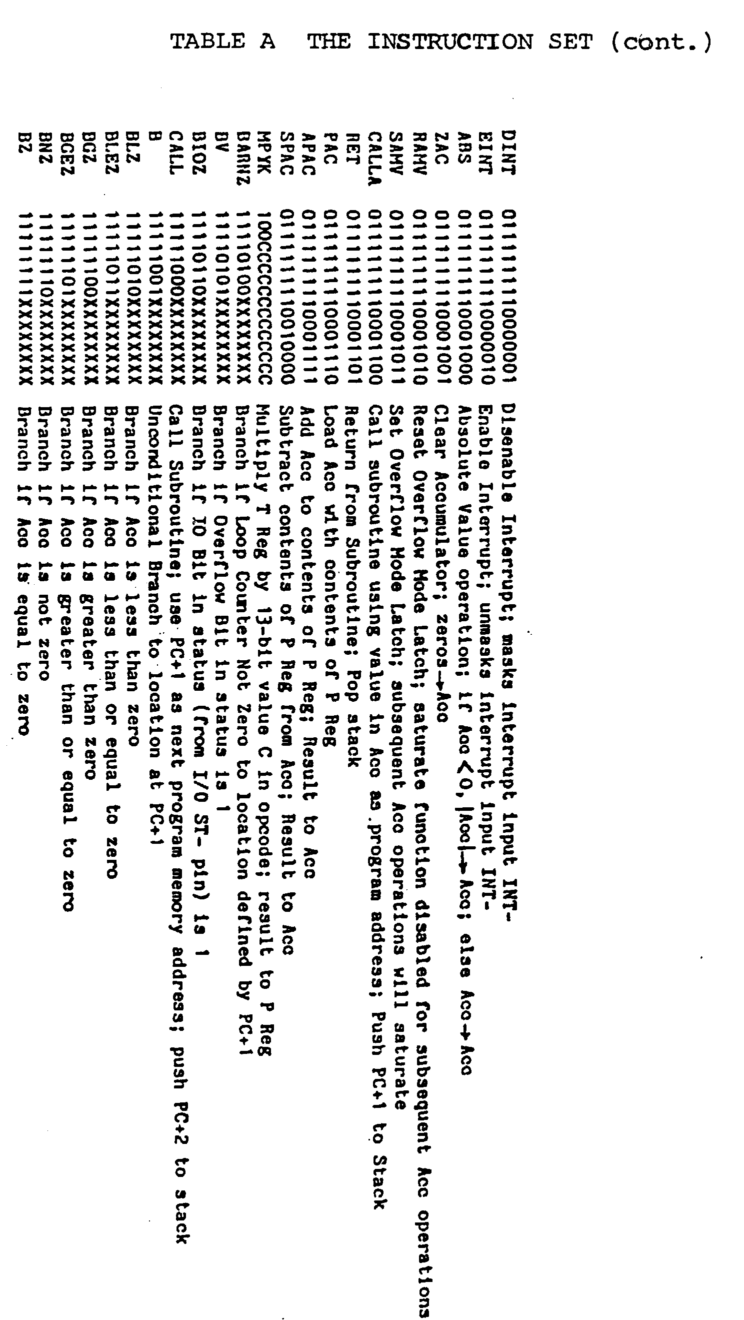

## Claims

1. A microcomputer device (10) for digital signal processing formed on a semiconductor substrate and having data terminals, comprising: an arithmetic/logic unit (ALU) having a data input (ALU-a, ALU-b) and a data output (ALU-o); a data memory (15) having an address input (15a) and having data input/output (15i,15j); a data bus (D-Bus) coupled to the data input and data output of the arithmetic/logic unit, to the data input/output of the data memory and to said data terminals (Dd); a program memory (14) having an address input (14a), the program memory storing at least instruction words; a program address circuit (PC) coupled to the address input of the program memory; a program bus (P-bus) coupled to said program address circuit; a control circuit (ID1) for generating control signals in response to instruction words to define the operation of said arithmetic/logic unit and transfer to and from the data bus; said control circuit including a timing circuit for generating clock voltages to establish operating cycles S0,S1,S2 and to establish sub-cycles Q1,Q2,Q3,Q4 within each operating cycle; said program memory having an instruction output (IR) coupled to said program bus, and said control circuit including a portion (ID2) coupled to said program bus; characterised in that during a single sub-cycle S1:Q3 the control circuit receives an instruction word defined by an address loaded into said program address circuit (PC) in a corresponding sub-cycle of a previous operating cycle S0,Q3 from said program bus and provides control signals (15a) for addressing said data memory (15), and an address defining a next instruction is loaded into said program address circuit (PC), said instruction on said program bus being provided by said instruction output (IR) of said program memory (14) addressed during a previous sub-cycle Q4;S0;S1,Q1; data from said memory being output to said data bus during a subsequent sub-cycle S1,Q4 and input to said arithmetic/logic unit (ALU) in a further subsequent sub-cycle S2,Q1 and said output (ALU-o) of said arithmetic/logic unit (ALU) being valid during a corresponding sub-cycle of a next operating cycle S2,Q3 during which an address of a yet further next instruction is loaded to said program address circuit (PC) and the next instruction is received by said control circuit (ID1).

2. A microcomputer device as set forth in claim 1 characterised in that it further comprises a shifter (S) connected between said data bus means and said arithmetic logic unit.

3. A microcomputer device as set forth in claim 2 characterised in that it further comprises shift control circuit means (Sc) connected to receive a shift value from said data bus means, said shift control circuit means being connected to said shifter and being responsive to said first-named control circuit for operating said shifter to shift data a number of bits represented by said shift value.

4. A microcomputer device as set forth in any of claims 1 to 3, characterised in that it further comprises a bus interface module (BIM) connected between said data bus means and said program bus, said bus interface module being selectively operable by said control circuit.

5. A microcomputer device as claimed in claim 4 and wherein said bus interface module transfers data to said program bus in a sub-cycle S2,Q2 subsequent to said single cycle S1.

6. A microcomputer device as set forth in any preceding claim, characterised in that it further comprises an accumulator (Acc) with sign extension connected to said arithmetic logic unit.

7. A microcomputer device as set forth in claim 6, characterised in that said accumulator is wider in bits than said data bus means.

8. A microcomputer device as set forth in either claim 6 or claim 7, characterised in that said control circuit includes means (Acc-H), Acc-L) for transferring higher and lower selected groups of bits from said accumulator to said data bus means.

9. A microcomputer device as set forth in any preceding claim characterised in that said arithmetic logic unit includes means (AUi, #AUM4) for executing logic operations of AND, OR and exclusive-OR as well as arithmetic addition in response to respective program instructions.

10. A microcomputer device as set forth in any preceding claim, characterised in that it further comprises bus means (RA) for external communications wherein said control circuit includes means (RAs) responsive to an externally supplied mode signal in a first mode for sending an address to said program memory for an instruction and executing the instruction and in a second mode sending the address to said bus means for external communications for any externally supplied instructions, instead of sending the address to said program memory.

11. A microcomputer system including a microcomputer device as set forth in any of the preceding claims, characterised in that the microcomputer device is formed in a single integrated circuit and is provided with data input/output terminals and address output terminals; said microcomputer system further including memory means (11) external to the microcomputer device and having an address input and data output means; external address bus means (RA) coupled to the address output terminals of the microcomputer device and to the address input of said memory means external to the microcomputer device; and external data bus means (D) coupled to the data input/output terminals of the microcomputer device and to the data output means of said memory means external to the microcomputer device.

12. A microcomputer system as set forth in claim 11 characterised in that successive operating cycles are overlapping.

13. A microcomputer system as set forth in claim 11 or claim 12, wherein the said microcomputer device is as claimed in claim 6 or claim 7, characterised in that said accumulator data output is coupled to one said data input of the arithmetic logic unit, and is also separately connected to said internal data bus means via high and low N bit word transfer means.

14. A microcomputer system as set forth in any one of claims 11 to 13, wherein the microcomputer device is as claimed in claim 6 or claim 7, characterised in that said microcomputer device further includes: means (ALU-A) connecting the accumulator data output to a data input of the arithmetic logic unit separate from the internal data bus means; said shifter being provided in the coupling from said internal data bus means to a data input of said arithmetic logic unit for shifting a selectable number of bits under control of the instruction word; and said timing means being effective for establishing overlapping operating cycles during a single one of which data may be transferred from the data memory to a data input of the arithmetic logic unit via said shifter.

15. A microcomputer system as set forth in any of claims 11 to 14, characterised in that the internal data bus means comprises a bus N bits in width and the data output of the arithmetic logic unit is 2N bits.

16. A microcomputer system as set forth in any of claims 11 to 15, including a microcomputer device according to claim 4 or claim 5, characterised in that said bus interface module (BIM) is effective for transferring the contents of the internal data bus means to the internal program bus means, and for transferring the contents of the internal program bus means to the internal data bus means, the bus interface module functioning under the control of a signal generated by the control circuit (ID1#BIFD) to transfer data from the output of the arithmetic logic unit via the internal data bus means and the internal program bus means to the program address means to thereby address the internal program memory means in the same operating sequence defined by an instruction word under the control of a signal generated by the control circuit portion (ID2#BIFP) to transfer data from the memory output of the internal program memory means via the internal program bus means to the internal data bus means.

17. A microcomputer system as set forth in any of claim 11 to 16, characterised in that it further includes: input/output peripheral means (12) for transfer of information to or from external equipment; said external address bus means and said external data bus means being coupled to said peripheral means.

18. A microcomputer system as set forth in any one of claims 11 to 17, characterised in that a multiplier (M) having first and second operand inputs (MI,TI) and a result output is included, the first and second operand inputs being loaded from said internal data bus means, one of said first and second operand inputs including temporary storage means (T REG), said result output being a product register (P REG), and selector means (ALU-S) controlled by said control circuit connecting either said product register or the output of said shifter to said data input of the arithmetic logic unit.

19. A microcomputer device as set forth in any of claims 1 to 10, further characterised by a multiplier (M) interconnected with said arithmetic logic unit and said data bus means.

## Patentansprüche

1. Mikrocomputervorrichtung (10) für digitale Signalverarbeitung, die auf einem Halbleitersubstrat gebildet ist und Datenanschlüsse besitzt, enthaltend: eine Arithmetik/Logik-Einheit (ALU) mit einem Dateneingang (ALU-a, ALU-b) und einem Datenausgang (ALU-o); einen Datenspeicher (15) mit einem Adresseneingang (15a) und einem Dateneingang/Datenausgang (15i, 15j); einen Datenbus (D-Bus), der an den Dateneingang und an den Datenausgang der Arithmetik/Logik-Einheit, an den Dateneingang/Datenausgang des Datenspeichers und an die Datenanschlüsse (Dd) angeschlossen ist; einen Programmspeicher (14) mit einem Adresseneingang (14a), wobei der Programmspeicher wenigstens Befehlswörter speichert; eine Programmadressenschaltung (PC), die an den Adresseneingang des Programmspeichers angeschlossen ist; einen Programmbus (P-Bus), der an die Programmadressenschaltung angeschlossen ist; eine Steuerschaltung (ID1) zum Erzeugen von Steuersignalen als Antwort auf Befehlswörter, um die operation der Arithmetik/Logik-Einheit und die Übertragung an den und von dem Datenbus zu definieren; wobei die Steuerschaltung eine Zeitgeberschaltung zum Erzeugen von Taktspannungen für die Erzeugung von Arbeitszyklen S0, S1, S2 und für die Erzeugung von Unterzyklen Q1, Q2, Q3, Q4 innerhalb jedes Arbeitszyklus enthält; wobei der Programmspeicher einen Befehlsausgang (IR) besitzt, der an den Programmbus angeschlossen ist, und die Steuerschaltung einen an den Programmbus angeschlossenen Abschnitt (ID2) enthält; dadurch gekennzeichnet, daß während eines einzigen Unterzyklus S1:Q3 die Steuerschaltung vom Programmbus ein Befehlswort, das durch eine in einem entsprechenden Unterzyklus eines vorhergehenden Arbeitszyklus S0, Q3 in die Programmadressenschaltung (PC) geladene Adresse definiert ist, empfängt und Steuersignale (15a) zum Adressieren des Datenspeichers (15) erzeugt, und eine Adresse, die einen nächsten Befehl definiert, in die Programmadressenschaltung (PC) geladen wird, wobei der Befehl auf dem Programmbus durch den Befehlsausgang (IR) des Programmspeichers (14), der in einem vorhergehenden Unterzyklus Q4; S0; S1, Q1 adressiert worden ist, bereitgestellt wird; wobei Daten vom Speicher zum Datenbus während eines nachfolgenden Unterzyklus S1, Q4 ausgegeben und in die Arithmetik/Logik-Einheit (ALU) in einem weiteren nachfolgenden Unterzyklus S2, Q1 eingegeben werden und der Ausgang (ALU-o) der Arithmetik/Logik-Einheit (ALU) während eines entsprechenden Unterzyklus eines nächsten Arbeitszyklus S2, Q3 gültig ist, in dem eine Adresse eines nochmals weiteren nächsten Befehls in die Programmadressenschaltung (PC) geladen wird und von der Steuerschaltung (ID1) der nächste Befehl empfangen wird.

2. Mikrocomputervorrichtung nach Anspruch 1, dadurch gekennzeichnet, daß sie ferner einen Schieber (S) enthält, der zwischen der Datenbuseinrichtung und der Arithmetik/Logik-Einheit angeschlossen ist.

3. Mikrocomputervorrichtung nach Anspruch 2, dadurch gekennzeichnet, daß sie ferner eine Verschiebungssteuerung-Schaltungseinrichtung (Sc) enthält, die so angeschlossen ist, daß sie einen Verschiebungswert von der Datenbuseinrichtung empfängt, wobei die Verschiebungssteuerung-Schaltungseinrichtung an den Schieber angeschlossen ist und auf die erstgenannte Steuerschaltung anspricht, um den Schieber in der Weise zu betreiben, daß er Daten um eine Anzahl von Bits verschiebt, die durch den Verschiebungsvert gegeben ist.

4. Mikrocomputervorrichtung nach irgendeinem der Ansprüche 1 bis 3, dadurch gekennzeichnet, daß er ferner einen Busschnittstellenmodul (BIM) enthält, der zwischen der Datenbuseinrichtung und dem Programmbus angeschlossen ist, wobei der Busschnittstellenmodul von der steuerschaltung selektiv betrieben werden kann.

5. Mikrocomputervorrichtung nach Anspruch 4, in der der Busschnittstellenmodul Daten an den Programmbus in einem dem Zyklus S1 folgenden Unterzyklus S2, Q2 überträgt.

6. Mikrocomputervorrichtung nach irgendeinem vorangehenden Anspruch, dadurch gekennzeichnet, daß sie ferner einen Akkumulator (Acc) mit Vorzeichenerweiterung enthält, der an die Arithmetik/Logik-Einheit angeschlossen ist.

7. Mikrocomputervorrichtung nach Anspruch 6, dadurch gekennzeichnet, daß der Akkumulator eine größere Bitbreite als die Datenbuseinrichtung besitzt.

8. Mikrocomputervorrichtung entweder nach Anspruch 6 oder nach Anspruch 7, dadurch gekennzeichnet, daß die Steuerschaltung eine Einrichtung (Acc-H, Acc-L) zum Übertragen von höheren und niedrigeren ausgewählten Gruppen von Bits vom Akkumulator an die Datenbuseinrichtung enthält.

9. Mikrocomputervorrichtung nach irgendeinem vorangehenden Anspruch, dadurch gekennzeichnet, daß die Arithmetik/Logik-Einheit eine Einrichtung (AUi, #AUM4) zum Ausführen von logischen UND-, ODER- und Exklusiv-ODER-operationen sowie arithmetischer Additionen als Antwort auf entsprechende Programmbefehle enthält.

10. Mikrocomputervorrichtung nach irgendeinem vorangehenden Anspruch, dadurch gekennzeichnet, daß sie ferner eine Buseinrichtung (RA) für externe Kommunikationen enthält, wobei die Steuerschaltung eine Einrichtung (RAs) enthält, die in einer ersten Betriebsart auf ein von außen geliefertes Betriebsartsignal anspricht, um an den Programmspeicher eine Adresse für einen Befehl zu schicken und den Befehl auszuführen, und in einer zweiten Betriebsart die Adresse, anstatt sie zum Programmspeicher zu senden, an die Buseinrichtung für externe Kommunikationen für irgendwelche von außen gelieferten Befehle sendet.

11. Mikrocomputersystem, das eine Mikrocomputervorrichtung nach irgendeinem der vorangehenden Ansprüche enthält, dadurch gekennzeichnet, daß die Mikrocomputervorrichtung in einer einzelnen integrierten Schaltung ausgebildet ist und mit Dateneingangs-/Datenausgangsanschlüssen sowie Adressenausgangsanschlüssen versehen ist; wobei das Mikrocomputersystem ferner versehen ist mit einer Speichereinrichtung (11) außerhalb der Mikrocomputervorrichtung, die eine Adresseneingabeund Datenausgabeeinrichtung besitzt; einer externen Adressenbuseinrichtung (RA), die an die Adressenausgangsanschlüsse der Mikrocomputervorrichtung und an den Adresseneingang der Speichereinrichtung außerhalb der Mikrocomputervorrichtung angeschlossen ist; und einer externen Datenbuseinrichtung (D), die an die Dateneingangs-/Datenausgangsanschlüsse der Mikrocomputervorrichtung und an die Datenausgangseinrichtung der Speichereinrichtung außerhalb der Mikrocomputervorrichtung angeschlossen ist.

12. Mikrocomputersystem nach Anspruch 11, dadurch gekennzeichnet, daß aufeinanderfolgende Arbeitszyklen überlappen.

13. Mikrocomputersystem nach Anspruch 11 oder 12, mit der Mikrocomputervorrichtung nach Anspruch 6 oder Anspruch 7, dadurch gekennzeichnet, daß der Akkumulator-Datenausgang an einen der Dateneingänge der Arithmetik/Logik-Einheit und außerdem getrennt hiervon über hohe und niedrige N-Bit-Wortübertragungseinrichtungen an die interne Datenbuseinrichtung angeschlossen ist.

14. Mikrocomputersystem nach irgendeinem der Ansprüche 11 bis 13, mit der Mikrocomputervorrichtung nach Anspruch 6 oder Anspruch 7, dadurch gekennzeichnet, daß die Mikrocomputervorrichtung ferner enthält: eine Einrichtung (ALU-A), die den Akkumulatordatenausgang getrennt von der internen Datenbuseinrichtung mit der Arithmetik/Logik-Einheit verbindet; wobei der Schieber in der Verbindung zwischen der internen Datenbuseinrichtung und dem Dateneingang der Arithmetik/Logik-Einheit vorgesehen ist, um unter der Steuerung des Befehlsworts eine ausgewählte Anzahl von Bits zu verschieben; und wobei die Zeitgebereinrichtung in der Weise wirkt, daß sie überlappende Arbeitszyklen erzeugt, wobei während eines einzigen von ihnen Daten vom Datenspeicher über den schieber an den Dateneingang der Arithmetik/Logik-Einheit übertragen werden können.

15. Mikrocomputersystem nach irgendeinem der Ansprüche 11 bis 14, dadurch gekennzeichnet, daß die interne Datenbuseinrichtung einen Bus mit einer Breite von N Bits enthält und der Datenausgang der Arithmetik/Logik-Einheit eine Breite von 2N Bits besitzt.

16. Mikrocomputersystem nach irgendeinem der Ansprüche 11 bis 15, mit einer Mikrocomputervorrichtung nach Anspruch 4 oder Anspruch 5, dadurch gekennzeichnet, daß der Busschnittstellenmodul (BIM) in der Weise wirkt, daß er die Inhalte der internen Datenbuseinrichtung an die interne Programmbuseinrichtung überträgt und die Inhalte der internen Programmbuseinrichtung an die interne Datenbuseinrichtung überträgt, wobei der Busschnittstellenmodul unter der Steuerung eines Signals arbeitet, das von der Steuerschaltung (ID1#BIFD) erzeugt wird, um Daten vom Ausgang der Arithmetik/Logik-Einheit über die interne Datenbuseinrichtung und die interne Programmbuseinrichtung zur Programmadresseneinrichtung zu übertragen, um dadurch die interne Programmspeichereinrichtung in derselben Arbeitsreihenfolge, die durch ein Befehlswort definiert ist, unter der Steuerung eines vom Steuerschaltungsabschnitt (ID2#BIFP) erzeugten Signals zu adressieren, um Daten vom Speicherausgang der internen Programmspeichereinrichtung über die interne Programmbuseinrichtung zur internen Datenbuseinrichtung zu übertragen.

17. Mikrocomputersystem nach irgendeinem der Ansprüche 11 bis 16, dadurch gekennzeichnet, daß es ferner enthält: eine Eingabe/Ausgabe-Peripherieeinrichtung (12) zum Übertragen von Informationen an eine externe Anlage oder von einer externen Anlage; wobei die externe Adressenbuseinrichtung und die externe Datenbuseinrichtung an die Peripherieeinrichtung angeschlossen sind.

18. Mikrocomputersystem nach irgendeinem der Ansprüche 11 bis 17, dadurch gekennzeichnet, daß ein Multiplizierer (M) mit einem ersten und einem zweiten Operandeneingang (MI, TI) und einem Ergebnisausgang, wobei der erste und der zweite Operandeneingang von der internen Datenbuseinrichtung geladen werden, wobei entweder der erste oder der zweite Operandeneingang eine Pufferspeichereinrichtung (T REG) enthält und wobei der Ergebnisausgang ein Produktregister (P REG) ist, sowie eine Wähleinrichtung (ALU-S) enthalten sind, die von der Steuerschaltung gesteuert wird und entweder das Produktregister oder den Ausgang des Schiebers mit dem Dateneingang der Arithmetik/Logik-Einheit verbindet.

19. Mikrocomputervorrichtung nach irgendeinem der Ansprüche 1 bis 10, ferner gekennzeichnet durch einen Multiplizierer (M), der zwischen die Arithmetik/Logik-Einheit und die Datenbuseinrichtung geschaltet ist.

## Revendications

1. Dispositif à micro-ordinateur (10) pour le traitement de signaux numériques, formé sur un substrat semiconducteur et comportant des bornes de transmission de données, comprenant : une unité arithmétique/logique (ALU) possédant une entrée de données (ALU-a, ALU-b) et une sortie de données (ALU-o) ; une mémoire de données (15) possédant une entrée d'adresses (15a) et une entrée/sortie de données (15i, 15j) ; un bus de transmission de données (D-bus) couplé à l'entrée de données et à la sortie de données du circuit arithmétique/logique, à l'entrée/ sortie de données de la mémoire de données et auxdites bornes de transmission de données (Dd) ; une mémoire de programme (14) possédant une entrée d'adresses (14a), la mémoire de programme mémorisant au moins des mots d'instructions ; un circuit (PC) de transmission d'adresses de programme couplé à l'entrée d'adresses de la mémoire de programme ; un bus de transmission de programme (P-bus) couplé audit circuit de transmission d'adresses de programme ; et un circuit de commande (ID1) pour produire des signaux de commande en réponse à des mots d'instruction de manière à définir le fonctionnement de l'unité arithmétique/logique et le transfert en provenance du bus de transmission de données ; ledit circuit de commande comportant un circuit de cadencement pour produire des tensions d'horloge pour établir des cycles de fonctionnement S0, S1, S2 et établir des cycles secondaires Q1, Q2, Q3, Q4 pendant chaque cycle de fonctionnement ; ladite mémoire de programme possédant une sortie d'instructions (IR) couplée audit bus de transmission de programme, et ledit circuit de commande comprenant une partie (ID2) couplée audit bus de transmission de programme ; caractérisé en ce que pendant un seul cycle secondaire S1 ; Q3, le circuit de commande reçoit un mot d'instruction défini par une adresse chargée dans ledit circuit de transmission d'adresses de programme (PC) dans un cycle secondaire correspondant d'un cycle de fonctionnement précédent, S0, Q3 à partir dudit bus de transmission de programme et envoie des signaux de commande (15a) pour l'adressage de ladite mémoire de données (15) et une adresse définissant une instruction suivante est chargée dans ledit circuit de transmission d'adresses de programme (PC), ladite instruction dans ledit bus de transmission de programme étant délivrée par ladite sortie d'instructions (IR) de ladite mémoire de programme (14) adressée pendant un cycle secondaire précédent Q4, S0 ; S1, Q1 ; des données provenant de ladite mémoire étant envoyées audit bus de transmission de données pendant un cycle secondaire suivant S1, Q4 et étant envoyées à ladite unité arithmétique/logique (ALU) lors d'un autre cycle secondaire suivant S2, Q1, et ladite sortie (ALU-o) de ladite unité arithmétique/logique (ALU) étant valable pendant un cycle secondaire correspondant d'un cycle suivant de fonctionnement S2, Q3, pendant lequel une adresse d'une autre instruction suivante est chargée dans ledit circuit de transmission d'adresses de programme (PC) et l'instruction suivante est reçue par ledit circuit de commande (ID1).

2. Dispositif à micro-ordinateur selon la revendication 1, caractérisé en ce qu'il comporte en outre un dispositif de décalage (S) branché entre lesdits moyens formant bus de transmission de données et ladite unité arithmétique/logique.

3. Dispositif à micro-ordinateur selon la revendication 2, caractérisé en ce qu'il comporte en outre des moyens (Sc) formant circuit de commande de décalage connectés de manière à recevoir une valeur de décalage à partir desdits moyens formant bus de transmission de données, lesdits moyens formant circuit de commande de décalage étant connectés audit dispositif de décalage et étant aptes à répondre audit circuit de commande mentionné en premier pour faire fonctionner ledit dispositif de décalage pour qu'il décale des données sur un nombre de bits représentés par ladite valeur de décalage.

4. Dispositif à micro-ordinateur selon l'une quelconque des revendications 1 à 3, caractérisé en ce qu'il comporte en outre un module d'interface de bus (BIM) connecté entre lesdits moyens formant bus de transmission de données et ledit bus de transmission de programme, ledit module d'interface de bus pouvant être activé de façon sélective par ledit circuit de commande.

5. Dispositif à micro-ordinateur selon la revendication 4 et dans lequel ledit module d'interface de bus transfère des données audit bus de transmission de programme lors d'un cycle secondaire S2, Q2 à la suite dudit cycle S1.

6. Dispositif à micro-ordinateur selon l'une quelconque des revendications précédentes, caractérisé en ce qu'il comporte en outre un accumulateur (Acc) avec une extension de signe, connecté à ladite unité arithmétique/logique.

7. Dispositif à micro-ordinateur selon la revendication 6, caractérisé en ce que ledit accumulateur possède une largeur en bits supérieure à celle desdits moyens formant bus de transmission de données.

8. Dispositif à micro-ordinateur selon l'une des revendications 6 ou 7, caractérisé en ce que ledit circuit de commande comprend des moyens (Acc-H, Acc-L), pour le transfert de groupes sélectionnés plus élevés et plus faibles de bits depuis ledit accumulateur en direction desdits moyens formant bus de transmission de données.

9. Dispositif à micro-ordinateur selon l'une quelconque des revendications précédentes, caractérisé en ce que ladite unité arithmétique/logique comprend des moyens (AUi, #AUM4) pour exécuter des opérations logiques ET, OU et OU-Exclusif, ainsi qu'une addition arithmétique en réponse à des instructions respectives du programme.

10. Dispositif à micro-ordinateur selon l'une quelconque des revendications précédentes, caractérisé en ce qu'il comporte en outre des moyens formant bus (RA) pour des communications externes, ledit circuit de commande comprenant des moyens (RAs) aptes à répondre à un signal de mode envoyé de l'extérieur, dans un premier mode pour l'envoi d'une adresse à ladite mémoire de programme pour une instruction et pour l'exécution d'instructions et, dans un second mode pour envoyer l'adresse auxdits moyens formant bus pour des communications externes pour n'importe quelle instruction introduite de l'extérieur, à la place de l'envoi de l'adresse à ladite mémoire de programme.

11. Système à micro-ordinateur comprenant un dispositif à micro-ordinateur selon l'une quelconque des revendications précédentes, caractérisé en ce que le dispositif à micro-ordinateur est formé dans un seul circuit intégré et est équipé de bornes d'entrée/de sortie de données et des bornes de sortie d'adresses ; ledit système à micro-ordinateur comprenant en outre des moyens de mémoire (11) situés à l'extérieur du dispositif à micro-ordinateur et possédant un moyen d'entrée d'adresses et des moyens de sortie de données ; les moyens (RA) formant bus externe de transmission d'adresses couplés aux bornes de sortie d'adresses du dispositif à micro-ordinateur et à l'entrée d'adresses desdits moyens de mémoire situés à l'extérieur du dispositif à micro-ordinateur ; et des moyens externes formant bus de transmission de données (D) couplés aux bornes d'entrée/de sortie de données du dispositif à micro-ordinateur et aux moyens de sortie de données desdits moyens de mémoire à l'extérieur du dispositif à micro-ordinateur.

12. Système à micro-ordinateur selon la revendication 11, caractérisé en ce que des cycles de fonctionnement successifs sont en chevauchement.

13. Système à micro-ordinateur selon la revendication 11 ou 12, dans lequel ledit dispositif à micro-ordinateur est tel que revendiqué dans la revendication 6 ou la revendication 7, caractérisé en ce que ladite sortie de données d'accumulateur est couplée à l'une desdites entrées de données de l'unité arithmétique/logique et est également connectée séparément auxdits moyens formant bus interne de transmission de données par l'intermédiaire de moyens de transfert de mots à N bits à niveau haut et à niveau bas.

14. Système à micro-ordinateur selon l'une quelconque des revendications 11 à 13, dans lequel le dispositif à micro-ordinateur est tel que revendiqué dans la revendication 6 ou la revendication 7, caractérisé en ce que ledit dispositif à micro-ordinateur comprend en outre : des moyens (ALU-A) connectant la sortie de données d'accumulateur à une entrée de données de l'unité arithmétique/logique, séparée des moyens formant bus interne de transmission de données, ledit dispositif de décalage étant prévu dans la liaison de couplage s'étendant desdits moyens formant bus interne de transmission de données jusqu'à une entrée de donnée de ladite unité arithmétique/logique pour décaler un nombre pouvant être sélectionné de bits sous la commande du mot d'instruction ; et lesdits moyens de cadencement étant efficaces pour établir des cycles de fonctionnement en chevauchement, pendant un seul desquels des données peuvent être transférées de la mémoire de données à une entrée de données de l'unité arithmétique/logique par l'intermédiaire dudit dispositif de décalage.

15. Système à micro-ordinateur selon l'une quelconque des revendications 11 à 14, caractérisé en ce que les moyens formant bus interne de transmission de données comprennent un bus d'une largeur de N bits et la sortie de données de l'unité arithmétique/logique est de 2 N bits.

16. Système à micro-ordinateur selon l'une quelconque des revendications 11 à 15, incluant un dispositif à micro-ordinateur selon la revendication 4 ou la revendication 5, caractérisé en ce que ledit module d'interface de bus (BIM) est efficace pour transférer le contenu des moyens formant bus interne de transmission de données aux moyens formant bus interne de transmission de programme, et pour le transfert du contenu des moyens formant bus interne de transmission de programme aux moyens formant bus interne de transmission de données, le module d'interface de bus fonctionnant sous la commande d'un signal produit par le circuit de commande (ID1#BIFD) pour transférer des données depuis la sortie de l'unité arithmétique/logique, par l'intermédiaire des moyens formant bus interne de transmission de données et des moyens formant bus interne de transmission de programme, aux moyens de transmission d'adresses de programme de manière à adresser ainsi les moyens formant mémoire interne de programme dans la même séquence de fonctionnement définie par un mot d'instruction sous la commande d'un signal produit par la partie formant circuit de commande ID2#BIFP) pour transférer des données depuis la sortie de mémoire des moyens formant mémoire interne de programme par l'intermédiaire des moyens formant bus interne de transmission de programme aux moyens formant bus interne de transmission de données.

17. Système à micro-ordinateur selon l'une quelconque des revendications 11 à 16, caractérisé en ce qu'il comporte en outre :
des moyens périphériques d'entrée/de sortie (12) pour le transfert d'une information en direction ou en provenance d'un équipement extérieur ; lesdits moyens formant bus externe de transmission d'adresses et lesdits moyens formant bus externe de transmission de données étant couplés auxdits moyens périphériques.

18. Système à micro-ordinateur selon l'une quelconque des revendications 11 à 17, caractérisé en ce qu'un multiplicateur (M) possédant des première et seconde entrées d'opérandes (MI, TI) et une sortie pour le résultat est incluse, les première et seconde unités d'opérandes étant chargées à partir desdits moyens formant bus interne de transmission de données, l'une desdites première et seconde entrées d'opérandes incluant des moyens de mémoire temporaire (T REG), ladite sortie pour le résultat étant un registre de produit (P REG), et des moyens de sélection (ALU-S) commandés par ledit circuit de commande connectant soit ledit registre de produits, soit la sortie dudit dispositif de décalage à ladite entrée de données de l'unité arithmétique/logique.

19. Dispositif à micro-ordinateur selon l'une quelconque des revendications 1 à 10, caractérisé en outre par un multiplicateur (M) interconnecté à ladite unité arithmétique/logique et auxdits moyens formant bus de transmission de données.
